(19) **Europäisches Patentamt European Patent Office Office européen des brevets**

(11) **EP 4 276 833 B1**

(12) **FASCICULE DE BREVET EUROPEEN**

(45) Date de publication et mention
de la délivrance du brevet:
**09.07.2025 Bulletin 2025/28**

(21) Numéro de dépôt: **23172627.4**

(22) Date de dépôt: **10.05.2023**

(51) Classification Internationale des Brevets (IPC):
***G11C 13/00*** *(2006.01)*     *G11C 11/54* *(2006.01)*

(52) Classification Coopérative des Brevets (CPC):
**G11C 13/0007; G11C 13/0026; G11C 13/0028;
G11C 13/003; G11C 13/004; G11C 13/0069;**
G11C 11/54; G11C 2013/005; G11C 2013/009;
G11C 2213/75; G11C 2213/79; G11C 2213/82

(54) **CELLULE MÉMOIRE, CIRCUIT ÉLECTRONIQUE COMPRENANT DE TELLES CELLULES, PROCÉDÉ DE PROGRAMMATION ET PROCÉDÉ DE MULTIPLICATION ET ACCUMULATION ASSOCIÉS**

SPEICHERZELLE, ELEKTRONISCHE SCHALTUNG MIT SOLCHEN ZELLEN, PROGRAMMIERVERFAHREN UND MULTIPLIZIER- UND AKKUMULATIONSVERFAHREN DAFÜR

MEMORY CELL, ELECTRONIC CIRCUIT COMPRISING SUCH CELLS, AND ASSOCIATED PROGRAMMING METHOD AND MULTIPLICATION AND ACCUMULATION METHOD

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **11.05.2022 FR 2204462**

(43) Date de publication de la demande:
**15.11.2023 Bulletin 2023/46**

(73) Titulaires:
• **Commissariat à l'Energie Atomique et aux Energies Alternatives
75015 Paris (FR)**
• **Université d'Aix Marseille
13007 Marseille (FR)**
• **Centre National de la Recherche Scientifique
75016 Paris (FR)**

(72) Inventeurs:
• **BONNET, Djohan
38054 GRENOBLE CEDEX 9 (FR)**
• **HIRTZLIN, Tifenn
38054 GRENOBLE CEDEX 9 (FR)**
• **VIANELLO, Elisa
38054 GRENOBLE CEDEX 9 (FR)**
• **ESMANHOTTO, Eduardo
38054 GRENOBLE CEDEX 9 (FR)**
• **PORTAL, Jean-Michel
13119 SAINT SAVOURNIN (FR)**

(74) Mandataire: **Lavoix
2, place d'Estienne d'Orves
75441 Paris Cedex 09 (FR)**

(56) Documents cités:
**EP-A1- 3 522 165     US-A1- 2012 287 697
US-B1- 10 482 953**

**Description**

La présente invention concerne une cellule mémoire pour circuit électronique.

L'invention concerne aussi un circuit électronique comprenant des lignes de valeur, des lignes de programmation, des lignes de source, et un ensemble de telles cellules mémoire.

L'invention concerne également un procédé de programmation d'au moins une cellule mémoire d'une rangée respective de cellules mémoire d'un tel circuit électronique.

L'invention concerne aussi un procédé de multiplication et accumulation d'un lot de cellule(s) mémoire d'une colonne respective de cellules mémoire d'un tel circuit électronique.

L'invention concerne de multiples applications, parmi lesquelles le traitement automatique de données, l'aide au diagnostic, l'analyse prédictive, les véhicules autonomes, la bioinformatique ou la surveillance. Ces applications impliquent typiquement la classification ou l'identification d'objets préalablement détectés par un capteur, permettant par exemple de reconnaître ou classer les identités de personnes dont le visage a été détecté par un détecteur de visages, ou encore de reconnaître ou de classer des objets environnants détectés par un capteur embarqué à bord d'un véhicule autonome, la reconnaissance ou encore la classification de tels objets étant importante pour la conduite autonome d'un tel véhicule.

Pour les multiples applications précitées, il est connu d'utiliser des algorithmes d'apprentissage automatique faisant partie de programmes pouvant être exécutés sur des processeurs, tels que les CPU (de l'anglais *Central Processing Unit*) ou les GPU (de l'anglais *Graphics Processing Unit*).

Parmi les techniques de mise en œuvre d'apprentissage, l'emploi de réseaux de neurones, c'est-à-dire des réseaux de neurones artificiels, ou ANN (de l'anglais *Artificial Neural Network*) connus en soi, est de plus en plus répandu, ces structures étant considérées comme très prometteuses du fait de leurs performances pour de nombreuses tâches telles que la classification automatique de données, la reconnaissance de motifs, la traduction et la compréhension automatique de langues, le contrôle robotique, la navigation automatique, les systèmes de recommandations, la détection d'anomalies, la détection de fraudes, l'étude de l'ADN ou encore la découverte de nouvelles molécules.

Un réseau de neurones est généralement composé d'une succession de couches de neurones dont chacune prend ses entrées sur les sorties de la couche précédente. Plus précisément, chaque couche comprend des neurones prenant leurs entrées sur les sorties des neurones de la couche précédente. Chaque couche est reliée par une pluralité de synapses. Un poids synaptique est associé à chaque synapse. C'est un nombre réel, qui prend des valeurs positives comme négatives. Pour chaque couche, l'entrée d'un neurone est la somme pondérée des sorties des neurones de la couche précédente, la pondération étant faite par les poids synaptiques.

Pour une implémentation dans un CPU ou un GPU, une problématique de goulot d'étranglement de Von Neumann (de l'anglais *Von Neumann bottleneck*) apparaît du fait que l'implémentation d'un réseau de neurones profond (à plus de trois couches et allant jusqu'à plusieurs dizaines) implique d'utiliser à la fois la ou les mémoires et le processeur alors que ces derniers éléments sont séparés spatialement. Il en résulte un engorgement du bus de communication entre la ou les mémoires et le processeur à la fois pendant que le réseau de neurones une fois entraîné est utilisé pour réaliser une tâche, et, à plus forte raison, pendant que le réseau de neurones est entraîné, c'est-à-dire pendant que ses poids synaptiques sont réglés pour résoudre la tâche en question avec un maximum de performance.

Il est donc souhaitable de développer des architectures matérielles dédiées, entremêlant mémoire et calcul, pour réaliser des réseaux de neurones rapides, à faible consommation et capables d'apprendre en temps réel.

US 2012/0287697 A1 décrit une cellule mémoire configurée pour l'écriture d'une valeur respective dans au moins un memristor via l'ouverture du ou de chaque commutateur primaire en parallèle d'au moins un memristor, la fermeture du ou de chaque éventuel autre commutateur primaire, la fermeture d'un commutateur secondaire et l'application d'une tension de programmation correspondante entre une première borne principale et une borne auxiliaire. La cellule mémoire est configurée pour la lecture d'une valeur respective dans au moins un memristor via l'ouverture du ou de chaque commutateur primaire en parallèle dudit au moins un memristor, la fermeture du ou de chaque éventuel autre commutateur primaire, l'ouverture du commutateur secondaire et la mesure d'une grandeur électrique correspondante entre les deux bornes principales.

US 10,482,953 B1 décrit une cellule mémoire comprenant en outre M commutateur(s) tertiaire(s), chacun étant connecté à un memristor respectif, le commutateur tertiaire et le memristor étant connectés en série, en parallèle du commutateur primaire associé.

Pour diminuer l'encombrement, il est connu d'utiliser des architectures dans lesquelles les synapses sont memristives. Des synapses memristives sont des synapses utilisant des memristors. En électronique, le memristor (ou memristance) est un composant électronique passif. Le nom est un mot-valise formé à partir des deux mots anglais memory et resistor. Un memristor est un composant de mémoire non-volatile, la valeur de sa résistance électrique changeant avec l'application d'une tension pendant une certaine durée, et restant à cette valeur en l'absence de tension.

Un exemple d'une telle implémentation est proposé dans un article de S. Jung et al. intitulé « A crossbar array of magnetoresistive memory devices for in-memory computing » publié le 12 janvier 2022 dans la revue Nature. Le réseau de neurones est réalisé par un ensemble de cellules mémoires de type 2T2R, en référence à la présence de deux commutateurs (appellation 2T) et de deux memristors (appellation 2R) pour chaque cellule mémoire.

Toutefois, cette implémentation porte sur un réseau de neurones particulier qui est un réseau de neurones binaires, ou BNN (de l'anglais *Binary Neural Network*), c'est-à-dire un réseau dans lequel les neurones et les synapses ne peuvent prendre que des valeurs binaires.

Le but de l'invention est alors de proposer une cellule mémoire, et un circuit électronique associé, permettant l'implémentation de tous types de réseaux de neurones, et notamment de réseaux autres que les réseaux de neurones binaires.

A cet effet, l'invention a pour objet un circuit électronique selon la revendication 1.

Avec le circuit électronique selon l'invention, la cellule mémoire autorise l'écriture, puis la lecture, de n'importe quelle valeur, sous forme de la valeur de la résistance électrique d'un memristor respectif inclus dans la cellule mémoire, et pas seulement d'une valeur binaire à la différence de la cellule mémoire de l'état de la technique.

De préférence, la cellule mémoire permet en outre la multiplication d'une valeur d'un memristor respectif par un multiple, via l'alternance - au cours d'un cycle d'inférence - d'ouverture(s) et de fermeture(s) du commutateur primaire en parallèle dudit memristor. Ceci permet alors typiquement la mise en œuvre d'une opération de multiplication et accumulation, également appelée MAC (de l'anglais *Multiplication and ACcumulation*).

Lors de l'inférence d'un réseau de neurones artificiels, chaque neurone artificiel est typiquement apte à effectuer une somme pondérée de valeur(s) reçue(s) en entrée de la part d'élément(s) connecté(s) à son entrée, tels que les neurones de la couche précédente, chaque valeur d'entrée étant alors multipliée par une valeur respective de poids synaptique, puis à appliquer une fonction d'activation, typiquement une fonction non-linéaire, à ladite somme pondérée, et à délivrer au(x) élément(s) connecté(s) à sa sortie la valeur résultant de l'application de ladite fonction d'activation. La cellule mémoire selon l'invention, et en particulier un ensemble de telles cellules mémoire connectées en série, sont alors particulièrement adaptés pour calculer efficacement la somme pondérée précitée.

Suivant d'autres aspects avantageux de l'invention, le circuit électronique est selon l'une quelconque des revendications 2 à 10.

Suivant d'autres aspects avantageux de l'invention, le circuit électronique comprend une ou plusieurs des caractéristiques suivantes, prises isolément ou suivant toutes les combinaisons techniquement possibles :

- la cellule mémoire comprend exactement M memristor(s) ;
- la cellule mémoire comprend exactement M+1 commutateurs ;

  la cellule mémoire étant de préférence constituée des première et deuxième bornes principales, de la borne auxiliaire, du memristor, et des commutateurs primaire(s) et secondaire ;

  - le ou chaque memristor est un composant mémoire résistif choisi parmi le groupe consistant en : un composant PCRAM, un composant OxRAM, un composant MRAM, et un composant CBRAM.
  - chaque commutateur est un transistor ;

  chaque transistor étant de préférence un transistor à effet de champ, tel qu'un transistor à effet de champ à grille isolée, ou MOSFET ;

  - l'ensemble de cellules mémoire est agencé sous forme d'une matrice comportant des rangées et des colonnes, les cellules mémoire d'une même rangée étant connectées à M même(s) ligne(s) de valeur et à une même ligne de source, et les cellules mémoire d'une même colonne étant connectées à une même ligne de programmation.

L'invention concerne aussi un procédé de programmation selon la revendication 11.

Suivant d'autres aspects avantageux de l'invention, le procédé de programmation comprend une ou plusieurs des caractéristiques suivantes, prises isolément ou suivant toutes les combinaisons techniquement possibles :

- le procédé comprend en outre, avant l'étape d'assignation, une étape de fermeture des commutateurs tertiaires des cellules mémoire de ladite rangée, via l'application d'une commande de fermeture sur la ou les lignes de programmation complémentaire connectées à ladite rangée ;

  lors de l'étape d'assignation, le premier potentiel électrique étant de préférence appliqué à la seule ligne de source reliée à l'au moins une première borne principale et le deuxième potentiel électrique étant appliqué à la seule ligne de source connectée à l'au moins une borne auxiliaire de ladite rangée ;
  le procédé comprenant de préférence encore, avant l'étape d'assignation, en outre une étape d'ouverture des autres commutateurs tertiaires, via l'application d'une commande d'ouverture sur la ou les autres lignes de programmation complémentaire du circuit électronique ;

- l'étape d'assignation comporte en outre la fermeture des commutateurs auxiliaires connectés aux lignes de source auxquelles l'un des premier et deuxième potentiels est appliqué ;

le commutateur auxiliaire associé à ladite rangée étant de préférence en outre commandé avec un potentiel prédéfini de limitation appliqué à son électrode de commande.

L'invention concerne également un procédé de multiplication et accumulation selon la revendication 12.

Suivant un autre aspect avantageux de l'invention, le procédé de multiplication et accumulation est selon la revendication 13.

L'invention concerne aussi un procédé de lecture d'au moins une cellule mémoire d'une rangée respective de cellules mémoire d'un circuit électronique tel que défini ci-dessus, le procédé comprenant les étapes suivantes :

- ouverture de commutateurs primaires des cellules mémoire de ladite rangée, via l'application d'une commande d'ouverture sur une ligne de valeur respective connectée à ladite rangée ;
- fermeture d'éventuels autres commutateurs primaires des cellules mémoire de ladite rangée, via l'application d'une commande de fermeture sur la ou les éventuelles autres lignes de valeur connectées à ladite rangée ;
- fermeture de l'au moins un commutateur secondaire de ladite au moins une cellule mémoire, via l'application d'une commande de fermeture sur l'au moins une ligne de programmation connectée à ladite au moins une cellule mémoire de ladite rangée ;
- lecture d'une valeur d'au moins un memristor de ladite au moins une cellule mémoire, avec une tension de lecture entre l'au moins une première borne principale et l'au moins une borne auxiliaire de ladite au moins une cellule mémoire, via l'application d'un troisième potentiel électrique au(x) ligne(s) de source agencée(s) du côté de l'au moins une première borne principale et d'un quatrième potentiel électrique au(x) autre(s) ligne(s) de source, agencée(s) du côté l'au moins une borne auxiliaire, la tension de lecture étant égale à la différence entre les troisième et quatrième potentiels, le ou chaque commutateur primaire en parallèle dudit au moins un memristor à lire étant ouvert.

L'invention concerne aussi un procédé de lecture d'un lot de cellule(s) mémoire d'une colonne respective de cellules mémoire d'un circuit électronique tel que défini ci-dessus, le procédé comprenant les étapes suivantes :

- ouverture des commutateurs secondaires des cellules mémoire de ladite colonne, via l'application d'une commande d'ouverture sur la ligne de programmation connectée à ladite colonne ;
- ouverture du commutateur primaire en parallèle du ou de chaque memristor à lire dudit lot de cellule(s) mémoire, via l'application d'une commande d'ouverture sur la ligne de valeur connectée à chaque commutateur primaire en parallèle du ou de chaque memristor à lire dudit lot ;
- fermeture de chaque éventuel autre commutateur primaire dudit lot de cellule(s) mémoire, via l'application d'une commande d'ouverture sur la ligne de valeur connectée à chaque éventuel autre commutateur primaire dudit lot ;
- si ledit lot n'inclut pas toutes les cellules mémoire de ladite colonne, fermeture de chaque commutateur primaire de chaque cellule mémoire distincte dudit lot au sein de ladite colonne, via l'application d'une commande de fermeture sur chaque ligne de valeur connectée à chaque cellule mémoire distincte dudit lot ;
- lecture d'une somme de valeur(s) de memristor(s) à lire dudit lot, via une mesure de la tension cumulée des cellules mémoire de ladite colonne.

Suivant un autre aspect avantageux de l'invention, le procédé de lecture comprend en outre, avant l'étape de lecture, une étape de fermeture de chaque commutateur tertiaire dudit lot, via l'application d'une commande de fermeture sur chaque ligne de programmation complémentaire connectée à chaque commutateur tertiaire dudit lot.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

- la figure 1 est une représentation schématique d'une cellule mémoire comprenant deux bornes principales et une borne auxiliaire, M memristors et M commutateurs primaires connectés entre les deux bornes principales, chaque commutateur primaire étant connecté en parallèle d'un memristor respectif, ainsi qu'un commutateur secondaire connecté entre la borne auxiliaire et l'une des bornes principales, dans le cas où M est strictement supérieur à 1, selon un premier mode de réalisation de l'invention ;
- la figure 2 est une représentation schématique d'un circuit électronique comprenant des lignes de valeur, des lignes de programmation, des lignes de source et un ensemble de cellules mémoire, chacune étant du type de la cellule mémoire de la figure 1, selon un premier exemple de réalisation ;
- la figure 3 est une vue analogue à celle de la figure 2, selon un deuxième exemple de réalisation, où le circuit

4

électronique comprend en outre des commutateurs auxiliaires connectés aux lignes de source ;

- la figure 4 est une vue analogue à celle de la figure 1, dans le cas où M est égal à 1;
- la figure 5 est une vue analogue à celle de la figure 2, dans le cas où M est égal à 1;
- la figure 6 est une vue analogue à celle de la figure 3, dans le cas où M est égal à 1;
- la figure 7 est une représentation schématique d'exemples de chronogramme de commande du commutateur primaire de la cellule mémoire, lors d'une opération de multiplication associée à celle-ci ;
- la figure 8 est un organigramme d'un procédé de programmation d'au moins une cellule mémoire d'une rangée respective de cellules mémoire du circuit électronique, selon le premier mode de réalisation de l'invention ;
- la figure 9 est un organigramme d'un procédé de multiplication et accumulation d'un lot de cellule(s) mémoire d'une colonne respective de cellules mémoire du circuit électronique, selon le premier mode de réalisation de l'invention ;
- la figure 10 est une vue analogue à celle de la figure 1, selon un deuxième mode de réalisation de l'invention, où la cellule mémoire comprend en outre M commutateur(s) tertiaire(s), chacun étant connecté à un memristor respectif, le commutateur tertiaire et le memristor étant connectés en série, en parallèle du commutateur primaire associé, avec M nombre entier supérieur ou égal à 1 ;
- la figure 11 est une vue analogue à celle de la figure 5, selon le deuxième mode de réalisation de l'invention, chaque cellule mémoire étant du type de la cellule mémoire de la figure 10 ;
- la figure 12 est une vue analogue à celle de la figure 8, selon le deuxième mode de réalisation de l'invention ; et
- la figure 13 est une vue analogue à celle de la figure 9, selon le deuxième mode de réalisation de l'invention.

Dans la présente description, sauf indication contraire, lorsqu'il est fait référence à deux éléments connectés entre eux, cela signifie de préférence qu'ils sont connectés directement entre eux, sans élément intermédiaire entre eux autre que des conducteurs de liaison ; et lorsqu'il est fait référence à deux éléments couplés ou reliés entre eux, cela signifie que ces deux éléments sont soit connectés entre eux, ou bien couplés ou reliés entre eux par l'intermédiaire d'un ou plusieurs autres éléments.

Dans la présente description, sauf autre précision, les expressions « sensiblement », « environ », « approximativement » et « de l'ordre de » définissent une relation d'égalité à plus ou moins 10%, de préférence à plus ou moins 5%.

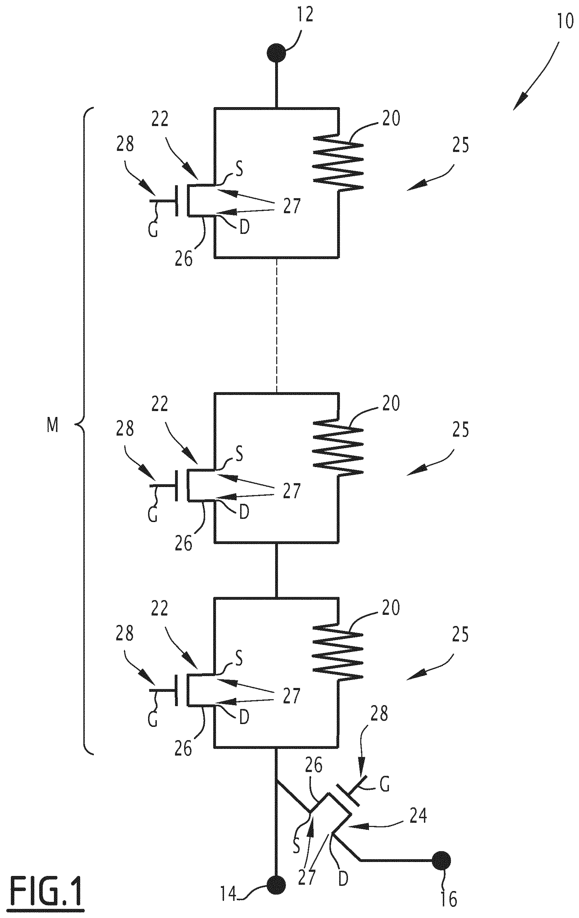

Sur la figure 1, une cellule mémoire 10 comprend une première borne principale 12, une deuxième borne principale 14 et une borne auxiliaire 16.

La cellule mémoire 10 comprend M memristor(s) 20 connecté(s) entre les deux bornes principales 12, 14, M étant un nombre entier supérieur ou égal à 1 ; M commutateur(s) primaire(s) 22, chacun étant connecté en parallèle d'un memristor 20 respectif ; et un commutateur secondaire 24 connecté entre la deuxième borne principale 14 et la borne auxiliaire 16. Chaque commutateur primaire 10 forme avec le memristor 20 respectif, en parallèle duquel il est connecté, une sous-cellule 25. Autrement dit, la cellule mémoire 10 comprend M sous-cellules 25 connectées en série les unes des autres entre les deux bornes principales 12, 14 ; et en outre le commutateur secondaire 24 connecté entre la deuxième borne principale 14 et la borne auxiliaire 16.

La cellule mémoire 10 est typiquement une cellule mémoire vive résistive, également appelée cellule RRAM ou cellule ReRAM (de l'anglais *Resistive Random Access Memory*).

La cellule mémoire 10 est configurée pour l'écriture d'une valeur respective dans au moins un memristor 20 via l'ouverture du ou de chaque commutateur primaire 22 en parallèle dudit au moins un memristor 20, la fermeture du ou de chaque éventuel autre commutateur primaire 22, la fermeture du commutateur secondaire 24 et l'application d'une tension de programmation correspondante entre la première borne principale 12 et la borne auxiliaire 16, c'est-à-dire aux extrémités du memristor 20.

L'homme du métier comprendra alors que cette écriture de valeur dans au moins un memristor 20 de la cellule mémoire 10 correspond à l'assignation d'une valeur de résistance audit au moins un memristor 20 par application de la tension de programmation correspondant à ladite valeur aux extrémités dudit au moins un memristor 20.

La cellule mémoire 10 est configurée aussi pour la lecture d'une valeur respective dans au moins un memristor 20 via l'ouverture du ou de chaque commutateur primaire 22 en parallèle dudit au moins un memristor 20, la fermeture du ou de chaque éventuel autre commutateur primaire 22, l'ouverture du commutateur secondaire 24 et la mesure d'une grandeur électrique correspondante entre les deux bornes principales 12, 14, c'est-à-dire aux extrémités dudit au moins un memristor 20.

L'homme du métier comprendra alors que cette lecture de la valeur contenue dans au moins un memristor 20 de la cellule mémoire 10 correspond à la lecture de la valeur de résistance dudit au moins un memristor 20, via la mesure de la grandeur électrique correspondante aux extrémités dudit au moins un memristor 20, par exemple via la mesure de la tension aux extrémités dudit au moins un memristor 20.

En complément facultatif, la cellule mémoire 10 est configurée en outre pour la multiplication d'une valeur d'au moins un memristor 20 respectif par un multiple, via une alternance d'ouverture(s) et de fermeture(s) du ou de chaque commutateur primaire 22 en parallèle dudit au moins un memristor 20 au cours d'un cycle d'inférence, la fermeture du ou de chaque éventuel autre commutateur primaire 22, l'ouverture du commutateur secondaire 24 et la mesure d'une grandeur électrique correspondante entre les deux bornes principales 12, 14. Un ratio ρ entre une durée cumulée d'ouverture du ou de chaque commutateur primaire 22 en parallèle dudit au moins un memristor 20 au cours du cycle d'inférence et une durée dudit cycle est représentatif du multiple respectif. Le ratio ρ est égal audit multiple.

Dans l'exemple de la figure 1, la cellule mémoire 10 comprend exactement M memristor(s) 20.

Dans l'exemple de la figure 1, la cellule mémoire 10 comprend exactement M+1 commutateurs 22, 24.

Dans l'exemple de la figure 1, la cellule mémoire 10 est alors constituée des première et deuxième bornes principales 12, 14, de la borne auxiliaire 16, du memristor 20, et des commutateurs primaire(s) et secondaire 22, 24.

Dans l'exemple de la figure 1, la cellule mémoire 10 est donc une cellule mémoire de type (M+1)TMR, en référence à la présence de M+1 commutateurs (appellation (M+1)T) et de M memristor(s) (appellation MR), et chaque sous-cellule 25 est de type 1T1R.

Dans l'exemple de la figure 1, le nombre entier M est strictement supérieur à 1.

Lorsque le nombre M est strictement supérieur à 1, l'homme du métier comprendra que l'écriture d'une valeur donnée dans un memristor 20 respectif est obtenue notamment via l'ouverture du commutateur primaire 22 en parallèle dudit memristor 20, et la fermeture du ou des M-1 autre(s) commutateur(s) primaire(s) 22, ce qui correspond alors au cas où d'éventuel(s) autre(s) commutateur(s) primaire(s) 22 sont à fermer.

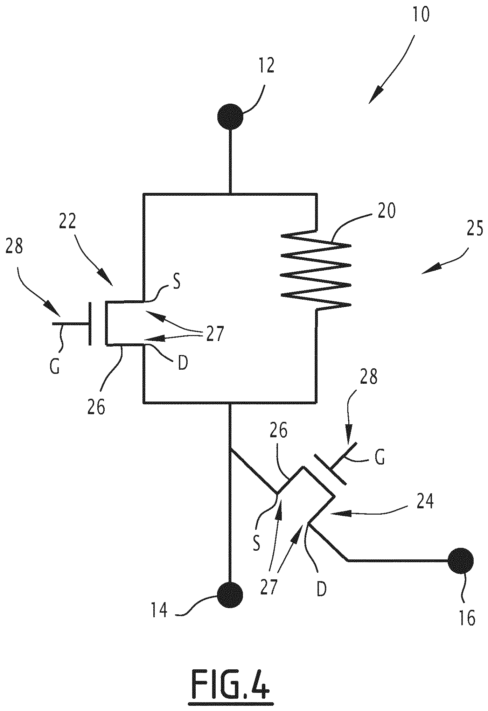

Lorsque le nombre M est en variante égal à 1, comme cela sera décrit plus en détail par la suite en regard des figures 4 à 6, l'homme du métier comprendra également que l'écriture d'une valeur donnée dans le memristor 20 de la cellule mémoire 10 est obtenue notamment via l'ouverture du commutateur primaire 22 qui est agencé en parallèle dudit memristor 20, et qu'il n'y a alors aucun éventuel autre commutateur primaire 22 à fermer dans ce cas.

L'homme du métier observera alors que la cellule mémoire 10 selon l'invention est une cellule de type 2T1R dans le cas où M est égal à 1, et comporte alors un memristor en moins que la cellule mémoire de type 2T2R de l'état de la technique.

L'homme du métier notera plus généralement que dans l'exemple de la figure 1, pour M supérieur à 1, la cellule mémoire 10 de type (M+1)TMR selon l'invention permet d'écrire M valeurs distincte(s), puis de lire et/ou inférer ces valeurs, chacune des M sous-cellules 25 étant associée à une valeur respective ; et que la cellule mémoire 10 est donc comparable à M cellules mémoire de type 2T2R de l'état de la technique, chaque sous-cellule 25 de type 1T1R selon l'invention étant comparable à la cellule mémoire de type 2T2R de l'état de la technique. L'homme du métier comprendra alors que la cellule mémoire 10 selon le premier mode de réalisation de l'invention comporte M memristors en moins, ainsi que (M-1) commutateur(s) en moins que les M cellules mémoire de type 2T2R correspondantes de l'état de la technique, ou encore que chaque sous-cellule 25 de type 1T1R selon le premier mode de réalisation comporte un memristor et un commutateur en moins que la cellule mémoire de type 2T2R de l'état de la technique.

Chaque memristor 20 est un composant électronique passif dont la valeur de sa résistance électrique change, de façon permanente, lorsqu'un courant est appliqué. Autrement dit, chaque memristor 20 est un composant résistif, et plus précisément un composant mémoire résistif. Ainsi, une donnée peut être enregistrée et réécrite par un courant de contrôle. Un tel comportement est notamment observé dans les matériaux à changement de phase, les jonctions tunnel ferroélectriques ou les mémoires redox à base d'oxydes, tels que le $HfO_x$ ou $TiO_{2-x}$.

Chaque memristor 20 est un composant de mémoire non-volatile, la valeur de sa résistance électrique changeant avec l'application d'une tension pendant une certaine durée et restant à cette valeur en l'absence de tension.

Le changement de conductance du memristor 20 dépend de l'amplitude et de la durée des impulsions de tension appliquées à travers le memristor 20, ainsi que de la valeur maximale de courant pouvant passer dans le memristor 20, par exemple pour une opération de « SET », c'est-à-dire le passage d'une résistance forte à une résistance faible. Une opération inverse de « RESET » correspond au passage d'une résistance faible à une résistance forte.

Le memristor 20 est susceptible de présenter deux états, à savoir un état haut et un état bas.

L'état haut correspond à une forte résistance et est généralement désigné par l'abréviation HRS (de l'anglais *High Resistive State*) qui signifie littéralement état fortement résistif. L'état haut est, de ce fait, dénommé état haut HRS par la suite.

L'état bas correspond à une faible résistance et est généralement désigné par l'abréviation LRS (de l'anglais *Low Resistive State*) qui signifie littéralement état faiblement résistif. L'état bas est, de ce fait, dénommé état bas LRS par la suite.

Le memristor 20 est par exemple un composant mémoire résistif choisi parmi le groupe consistant en : un composant PCRAM (de l'anglais *Phase-Change Random Access Memory*), un composant OxRAM (de l'anglais *hafnium-oxide RRAM,* i.e. *hafnium-oxide Resistive Random Access Memory*), un composant MRAM (de l'anglais *Magnetic Random Access Memory*), et un composant CBRAM (de l'anglais *Conductive Bridging Random Access Memory*).

L'homme du métier notera que le composant PCRAM est également connu sous les dénominations équivalentes suivantes : composant PCM (de l'anglais *Phase Change Memory*), composant PRAM (de l'anglais *Phase-change Random Access Memory*), composant OUM (de l'anglais *Ovonic Unified Memory*), et composant C-RAM ou CRAM (de l'anglais *Chalcogenide Random Access Memory*).

Chaque commutateur primaire 22 est également appelé interrupteur primaire. Chaque commutateur primaire 22 est par exemple réalisé sous forme d'un transistor 26.

Le commutateur secondaire 24 est de manière analogue également appelé interrupteur secondaire. Le commutateur secondaire 24 est par exemple réalisé sous forme du transistor 26.

Chaque commutateur 22, 24 comporte, comme connu en soi, deux électrodes de conduction 27 et une électrode de commande 28.

Le transistor 26 est typiquement un transistor à effet de champ, également appelé FET (de l'anglais *Field Effect Transistor).* Le transistor à effet de champ est, par exemple, un transistor à effet de champ à grille isolée, également appelé MOSFET (de l'anglais *Metal Oxide Semiconductor Field Effect Transistor).* En variante, le transistor à effet de champ est un transistor à effet de champ à jonction, également appelé JFET (de l'anglais *Junction Field Effect Transistor) ;* un transistor à effet de champ avec une grille métallique, également appelé MESFET (de l'anglais *MEtal Semiconductor Field Effect Transistor*) ;un transistor à effet de champ à haute mobilité d'électrons, également appelé MODFET (de l'anglais *MOdulated-Doping Field Effect Transistor*) ou HEMT (de l'anglais *High Electron Mobility Transistor*) ; un transistor à effet de champ organique, également appelé OFET (de l'anglais *Organic Field Effect Transistor) ;* un transistor CNFET (de l'anglais *Carbon Nanotube Field Effect Transistor) ;* un transistor EOSFET (de l'anglais *Electrolyte Oxide Semiconductor Field Effect Transistor*) ; un transistor CMOS (de l'anglais *Complementary Metal Oxide Semiconductor*) ; un transistor FDSOI (de l'anglais *Fully Depleted Silicon On Insulator) ;* un transistor FinFET (de l'anglais *Fin Field-Effect Transistor) ;* ou encore un transistor ISFET (de l'anglais *Ion Sensitive Field Effect Transistor*).

Lorsque le transistor 26 est un transistor à effet de champ, les électrodes de conduction 27 sont, comme connu en soi, des électrodes de source S et de drain D, l'électrode de commande 28 étant une électrode de grille G.

Dans l'exemple de la figure 1, le transistor 26 formant le commutateur primaire 22 d'une première sous-cellule 25 connectée directement à la première borne principale 12 est connecté par son électrode de source S à ladite première borne principale 12 et par son électrode de drain D à la sous-cellule 25 suivante, en particulier à l'électrode de source S du transistor 26 formant le commutateur primaire 22 de ladite sous-cellule 25 suivante. Le transistor 26 formant le commutateur primaire 22 d'une sous-cellule 25 respective de la série est connecté par son électrode de source S à la sous-cellule 25 précédente, en particulier à l'électrode de drain D du transistor 26 formant le commutateur primaire 22 de ladite sous-cellule 25 précédente ; et respectivement par son électrode de drain D à la sous-cellule 25 suivante, en particulier à l'électrode de source S du transistor 26 formant le commutateur primaire 22 de ladite sous-cellule 25 suivante. Le transistor 26 formant le commutateur primaire 22 de la dernière sous-cellule 25 connectée directement à la deuxième borne principale 14 est connecté par son électrode de source S à la sous-cellule 25 précédente, en particulier à l'électrode de drain D du transistor 26 formant le commutateur primaire 22 de ladite sous-cellule 25 précédente ; et respectivement par son électrode de drain D à la deuxième borne principale 14. Le transistor 26 formant le commutateur secondaire 24 est connecté par son électrode de source S à la deuxième borne principale 14 et par son électrode de drain D à la borne auxiliaire 16.

En variante, le transistor 26 est un transistor bipolaire ; ou un transistor bipolaire à grille isolée, également appelé IGBT (de l'anglais *Insulated Gate Bipolar Transistor).*

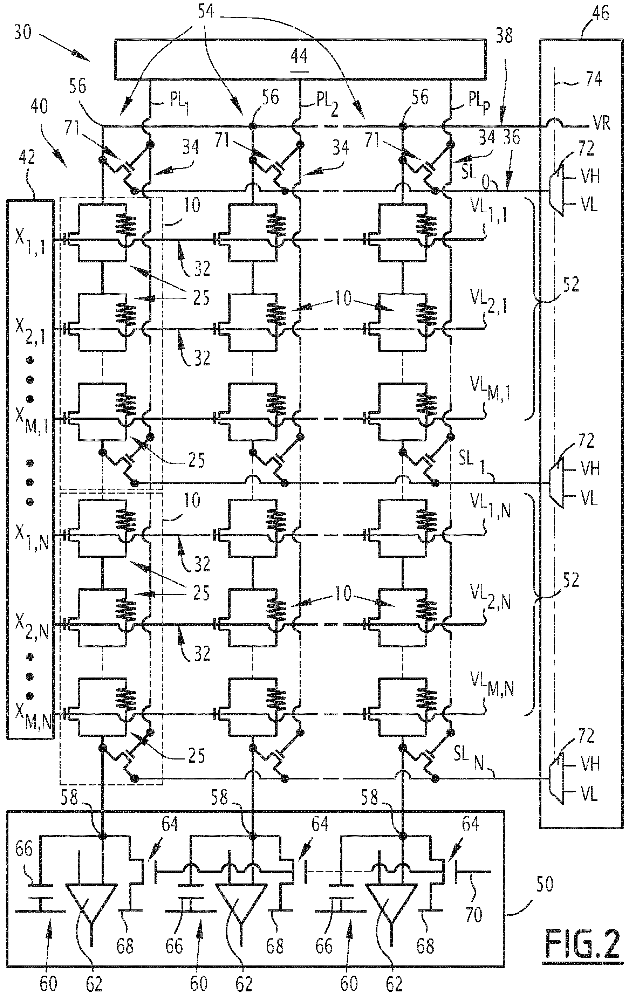

Sur la figure 2, un circuit électronique 30 comprend des lignes de valeur 32, des lignes de programmation 34, des lignes de source 36; et un ensemble 40 de cellules mémoire 10, chaque cellule mémoire 10 étant telle que définie ci-dessus.

Pour chaque cellule mémoire 10, l'électrode de commande 28 de chaque commutateur primaire 22 est connectée à une ligne de valeur 32 respective, l'électrode de commande 28 du commutateur secondaire 24 est connectée à une ligne de programmation 34 respective, et la borne auxiliaire 16 est connectée à une ligne de source 36 respective.

En complément, le circuit électronique 30 comprend une ligne de référence 38 à laquelle est appliquée un potentiel de référence VR.

En complément, le circuit électronique 30 comprend un premier contrôleur 42 configuré pour contrôler, c'est-à-dire piloter ou encore commander, chacune des lignes de valeur 32 ; un deuxième contrôleur 44 configuré pour contrôler chacune des lignes de programmation 34 ; et un troisième contrôleur 46 configuré pour contrôler chacune des lignes de source 36, ainsi qu'en complément la ligne de référence 38.

En complément encore, le circuit électronique 30 comprend un dispositif de mesure 50 configuré pour effectuer des mesures représentatives des grandeurs électriques des cellules mémoire 10 de l'ensemble 40, telles que les tensions aux extrémités des memristors 20 desdites cellules mémoire 10.

L'ensemble 40 de cellules mémoire 10 est agencé de sorte à comporter un ou plusieurs sous-ensembles de cellules mémoire 10, où les cellules mémoire 10 sont connectées en série les unes les autres au sein de chaque sous-ensemble respectif.

L'ensemble 40 de cellules mémoire 10 est typiquement agencé sous forme d'une matrice comportant des rangées 52 (de l'anglais *row*) et des colonnes 54 (de l'anglais *column*). Selon cet agencement, chaque rangée 52 est de préférence disposée horizontalement, et chaque colonne 54 est de préférence disposée verticalement. Les cellules mémoire 10 d'une même rangée 52 sont par exemple connectées à une même ligne de valeur 32 et à une même ligne de source 36, et les cellules mémoire 10 d'une même colonne 54 sont par exemple connectées à une même ligne de programmation 34.

Lorsque l'ensemble 40 est agencé sous forme matricielle, le nombre de rangées 52 est de préférence sensiblement égal au nombre de colonnes 54.

Selon cet agencement, les cellules mémoire 10 d'une même colonne 54 sont connectées en série les unes des autres, chaque colonne 54 comportant une première extrémité 56 connectée au potentiel de référence VR et une deuxième extrémité 58 connectée à un module de mesure 60 respectif. Chaque module de mesure 60 est configuré pour mesurer une tension cumulée des cellules mémoire 10 de la colonne 54 à laquelle il est connecté.

Selon cet agencement, chaque deuxième borne principale 14 d'une cellule mémoire 10 donnée d'une colonne 54 respective est alors connectée à la première borne principale 12 d'une cellule mémoire 10 suivante de ladite colonne 54, la deuxième borne principale 14 d'une dernière cellule mémoire de ladite colonne 54 étant connectée à un module de mesure 60 respectif, et la première borne principale 12 d'une première cellule mémoire 10 de ladite colonne 54 étant alors connectée à la ligne de référence 38.

Selon cet agencement, le dispositif de mesure 50 comporte les modules de mesure 60. Le dispositif de mesure 50 comporte typiquement un module de mesure 60 respectif pour chacune des colonnes 54.

Chaque module de mesure 60 comporte par exemple un comparateur 62 configuré pour détecter l'atteinte, par la tension cumulée des cellules mémoire 10 de la colonne 54 respective, d'une tension prédéfinie de seuil Uth respective.

En complément, chaque module de mesure 60 comporte un commutateur de réinitialisation 64 et un condensateur 66. Le condensateur 66 est configuré, d'une part, pour être chargé par la tension cumulée des cellules mémoire 10 de la colonne 54 respective lors d'une phase de mesure, le commutateur de réinitialisation 64 étant alors ouvert ; et d'autre part, pour être déchargé par mise à une masse électrique 68 via la fermeture du commutateur de réinitialisation 64 lors d'une phase de réinitialisation.

En complément, le dispositif de mesure 50 comporte une ligne de mesure 70 connectée à chacun des commutateurs de réinitialisation 64, en particulier à leur électrode de commande, pour permettre une commande simultanée des commutateurs de réinitialisation 64, et alors une commande simultanée des différents modules de mesure 60.

Les lignes de valeur 32 sont également notées $VL_{i,k}$ avec i un indice entier variant de 1 à M où M représente le nombre de memristors 20 dans chaque cellule mémoire 10, qui est égal au nombre de commutateurs primaires 22 dans chaque cellule mémoire 10, M représentant alors aussi le nombre de commutateurs primaires 22 au sein de chaque cellule mémoire 10 ; et k un indice entier variant de 1 à N, où N représente le nombre de rangées 52. Plus précisément, les lignes de valeur 32 sont alors notées $VL_{1,1}$, $VL_{2,1}$, ..., $VL_{M,1}$ pour la première rangée 52 d'indice k égal à 1 ; puis $VL_{1,2}$, $VL_{2,2}$, ..., $VL_{M,2}$ pour la deuxième rangée 52 d'indice k égal à 2 ; jusqu'à $VL_{1,N}$, $VL_{2,N}$, ..., $VL_{M,N}$ pour la dernière rangée 52 d'indice k égal à N.

L'ensemble 40 comprend typiquement entre 32 et 2 000 sous-cellules 25, et de préférence de quelques centaines à environ 1000 sous-cellules 25.

Le nombre M de sous-cellules 25 par cellule mémoire 10 est typiquement compris entre quelques unités et quelques dizaines.

Les lignes de programmation 34 sont également notées $PL_j$, j étant un indice entier variant de 1 à P, où P représente le nombre de colonnes 54. Les lignes de programmation 34 sont alors notées $PL_1$, $PL_2$, ..., $PL_P$.

Les lignes de source 36 sont également notées $SL_k$, avec k l'indice entier variant de 1 à N, où N représente le nombre de rangées 52. Les lignes de source 36 sont alors notées $SL_1$, $SL_2$, ..., $SL_N$.

En complément, le circuit électronique 30 comprend une ligne de source 36 supplémentaire, notée $SL_0$, permettant d'appliquer un potentiel prédéfini aux premières bornes principales 12 des cellules mémoire 10 de la première rangée de l'ensemble 40 lors de leur programmation.

Selon ce complément, le circuit électronique 30 comprend en outre un commutateur de tête 71 pour chaque colonne 54, chaque commutateur de tête 71 respectif étant connecté entre la première borne principale 12 de la cellule mémoire 10 respective de la première rangée et la ligne de source 36 supplémentaire $SL_0$. Selon ce complément, les électrodes de conduction 27 du commutateur de tête 71 sont alors connectées à la première borne principale 12 respective d'une part et à la ligne de source supplémentaire $SL_0$ d'autre part, et l'électrode de commande 28 du commutateur de tête 71 est connectée à une ligne de programmation 34 respective. Dans l'exemple de la figure 2, chaque commutateur de tête 71 est réalisé sous forme du transistor 26, celui-ci étant de préférence un transistor à effet de champ, et est connecté par son électrode de drain D à la ligne de source supplémentaire $SL_0$, par son électrode de source S à la première borne principale 12 respective, et par son électrode de grille G à la ligne de programmation 34 respective.

La ligne de référence 38 est configurée pour charger le condensateur 66 de chaque module de mesure 60 lors de la phase de mesure, en appliquant le potentiel de référence VR à travers les cellules de mesure 10 d'une colonne 54 respective jusqu'au condensateur 66.

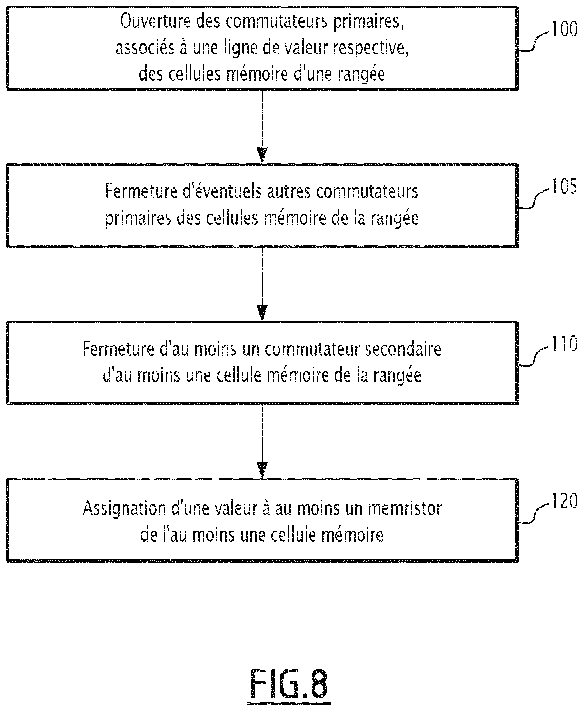

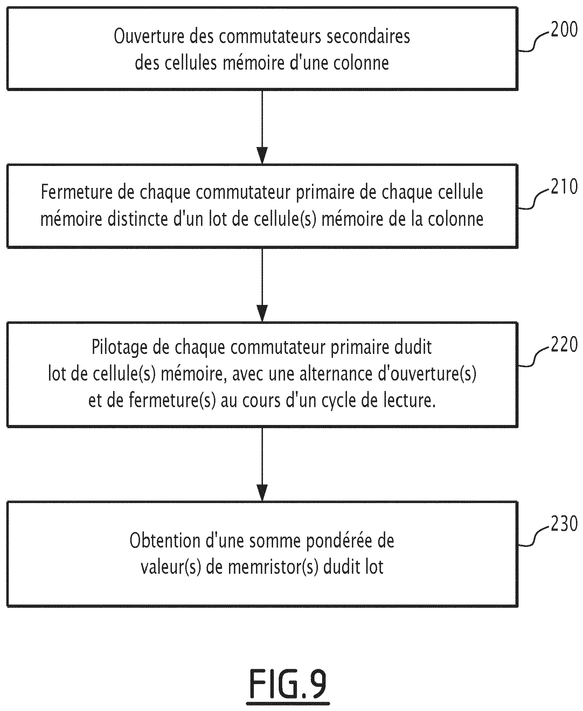

Le premier contrôleur 42 est configuré pour contrôler chacune des lignes de valeur 32 connectées aux électrodes de commande 28 des commutateurs primaires 22 de l'ensemble 40 de cellules mémoire, en fonction de l'opération effectuée sur les cellules mémoire 10, notamment parmi une opération de programmation, c'est-à-dire une opération d'écriture, lorsque le procédé de programmation selon l'invention est mis en œuvre ; et respectivement une opération d'inférence lorsque le procédé de multiplication et accumulation selon l'invention est mis en œuvre ; comme cela sera décrit plus en détail par la suite en regard de la figure 8, et respectivement de la figure 9 ; ainsi qu'une opération de lecture lorsque le procédé de lecture selon l'invention est mis en œuvre.

Le premier contrôleur 42 est par exemple configuré pour commander les commutateurs primaires 22 d'une rangée 52 respective, lors de la programmation de cellule(s) mémoire 10 de ladite rangée 52, en particulier l'ouverture des commutateurs primaires 22 connectés à une ligne de valeur 32 respective associée à ladite rangée et la fermeture des éventuels autres commutateurs primaires 22 des cellules mémoire 10 de ladite rangée 52, ces éventuels autres commutateurs primaires 22 étant alors connectés à d'autres lignes de valeur 32 que celle à laquelle un signal d'ouverture est appliqué.

Le premier contrôleur 42 est par exemple configuré pour commander une alternance d'ouverture(s) et de fermeture(s) de commutateurs primaires 22 d'une colonne 54 respective, lors de la mise en œuvre d'une opération d'inférence avec un lot de cellule(s) mémoire 10 de ladite colonne 54.

Lorsque le procédé de multiplication et accumulation selon l'invention est mis en œuvre, le premier contrôleur 42 est typiquement configuré pour piloter chaque commutateur primaire 22 dudit lot de cellule(s) mémoire avec l'alternance d'ouverture(s) et de fermeture(s) au cours d'un cycle d'inférence, en appliquant les commandes alternées d'ouverture(s) et de fermeture(s) sur chaque ligne de valeur 32 connectée à chaque commutateur primaire 22 dudit lot, pour multiplier la valeur de chaque memristor 20 dudit lot par un multiple respectif. Le ratio $\rho$ entre la durée cumulée d'ouverture du commutateur primaire 22 respectif au cours du cycle d'inférence et la durée dudit cycle représente le multiple respectif.

Le multiple respectif pour chaque ligne de valeur 32 est noté $X_{i,k}$, avec i l'indice entier variant de 1 à M et k l'indice entier variant de 1 à N, où M représente le nombre de commutateurs primaires 22 par cellule mémoire 10 et N représente le nombre de rangées 52. Le multiple $X_{i,k}$ respectif est égal audit ratio $\rho$, comme cela sera décrit plus en détail par la suite en regard de la figure 9 et de l'organigramme associé du procédé de multiplication et accumulation selon l'invention. De manière analogue à ce qui a été décrit précédemment pour les lignes de valeur 32, les multiples sont alors notés $X_{1,1}$, $X_{2,1}$, ..., $X_{M,1}$ pour la première rangée 52 d'indice k égal à 1 ; puis $X_{1,2}$, $X_{2,2}$, ..., $X_{M,2}$ pour la deuxième rangée 52 d'indice k égal à 2 ; jusqu'à $X_{1,N}$, $X_{2,N}$, ..., $X_{M,N}$ pour la dernière rangée 52 d'indice k égal à N.

Le deuxième contrôleur 44 est configuré pour contrôler chacune des lignes de programmation 34 connectées aux électrodes de commande 28 des commutateurs secondaires 24 de l'ensemble 40 de cellules mémoire, et en complément des commutateurs de tête 71, en fonction de l'opération effectuée sur les cellules mémoire 10, notamment parmi l'opération de programmation, l'opération d'inférence et l'opération de lecture précitées.

Le deuxième contrôleur 44 est par exemple configuré pour commander la fermeture du commutateur secondaire 24 de chaque cellule mémoire 10 à programmer, lors de la programmation de cellule(s) mémoire 10 d'une rangée 52 respective.

Le deuxième contrôleur 44 est par exemple configuré pour commander l'ouverture des commutateurs secondaires 24 des cellules mémoire 10 d'une colonne 54 respective, lors de la mise en œuvre de l'opération d'inférence avec le lot de cellule(s) mémoire 10 de ladite colonne 54. Le deuxième contrôleur 44 est de préférence configuré pour commander l'ouverture de tous les commutateurs secondaires 24 de l'ensemble 40 de cellules mémoire lors de ladite opération d'inférence.

Le troisième contrôleur 46 est configuré pour contrôler chacune des lignes de source 36 connectées aux électrodes de conduction 27 respectives des commutateurs secondaires 24 de l'ensemble 40 de cellules mémoire, en fonction de l'opération effectuée sur les cellules mémoire 10, notamment parmi l'opération de programmation, l'opération d'inférence et l'opération de lecture précitées.

Lors de l'opération de programmation, pour assigner une valeur respective à chacun des memristors 20 de chaque cellule mémoire 10 à programmer, le troisième contrôleur 46 est par exemple configuré pour imposer une tension de programmation correspondant à ladite valeur entre la première borne principale 12 et la borne auxiliaire 16 de chaque cellule mémoire 10 à programmer, en appliquant un premier potentiel électrique V1 au(x) ligne(s) de source 36 agencée(s) du côté de ladite première borne principale 12 et un deuxième potentiel électrique V2 au(x) autre(s) ligne(s) de source 36, agencée(s) du côté ladite borne auxiliaire 16. La tension de programmation correspondant à la valeur assignée est égale à la différence entre les premier V1 et deuxième V2 potentiels. Lors de cette opération de programmation, le commutateur primaire 22 connecté en parallèle du memristor 20 - auquel la valeur respective est assignée - est en outre ouvert, pendant que le ou les autres commutateurs primaires 22 de la cellule mémoire 10 respective sont fermés, ceci par le premier contrôleur 42.

Le troisième contrôleur 46 comporte par exemple des multiplexeurs 72 et un bus de sélection 74 connecté aux multiplexeurs 72, chaque ligne de source 36 étant connectée à un multiplexeur 72 respectif. Selon cet exemple, chaque multiplexeur 72 est alors configuré pour sélectionner, en fonction d'un signal de sélection respectif appliqué sur le bus de sélection 74 et parmi plusieurs valeurs prédéfinies VH, VL, une valeur de potentiel électrique à appliquer à la ligne de source 36 associée. Les valeurs prédéfinies VH, VL correspondent typiquement aux valeurs possibles des premier V1 et deuxième V2 potentiels précités, dont la différence est égale à la tension de programmation à imposer entre la première borne principale 12 et la borne auxiliaire 16 de la cellule mémoire 10 pour assigner la valeur respective souhaitée à chacun des memristors 20 de cette cellule mémoire 10 à programmer.

Lors de l'opération d'inférence, ou encore lors de l'opération de lecture, le troisième contrôleur 46 est par exemple configuré pour appliquer un potentiel par défaut aux différentes lignes de source 36, les commutateurs secondaires 24 étant ouverts lors de l'opération d'inférence, ou encore lors de l'opération de lecture, et ces lignes de source 36 n'étant alors pas utilisées.

En complément, le troisième contrôleur 46 est configuré pour appliquer le potentiel de référence VR à la ligne de référence 38.

Dans l'exemple de la figure 2, le premier contrôleur 42, le deuxième contrôleur 44 et le troisième contrôleur 46 sont réalisés sous forme de contrôleurs distincts les uns des autres. En variante, au moins deux des trois contrôleurs 42, 44, 46 précités, voire les trois contrôleurs 42, 44, 46 sont regroupés en unique contrôleur configuré alors pour contrôler plusieurs types de lignes, voire tous les types de lignes, parmi les lignes de valeur 32, les lignes de programmation 34 et les lignes de source 36, ainsi qu'en complément la ligne de référence 38.

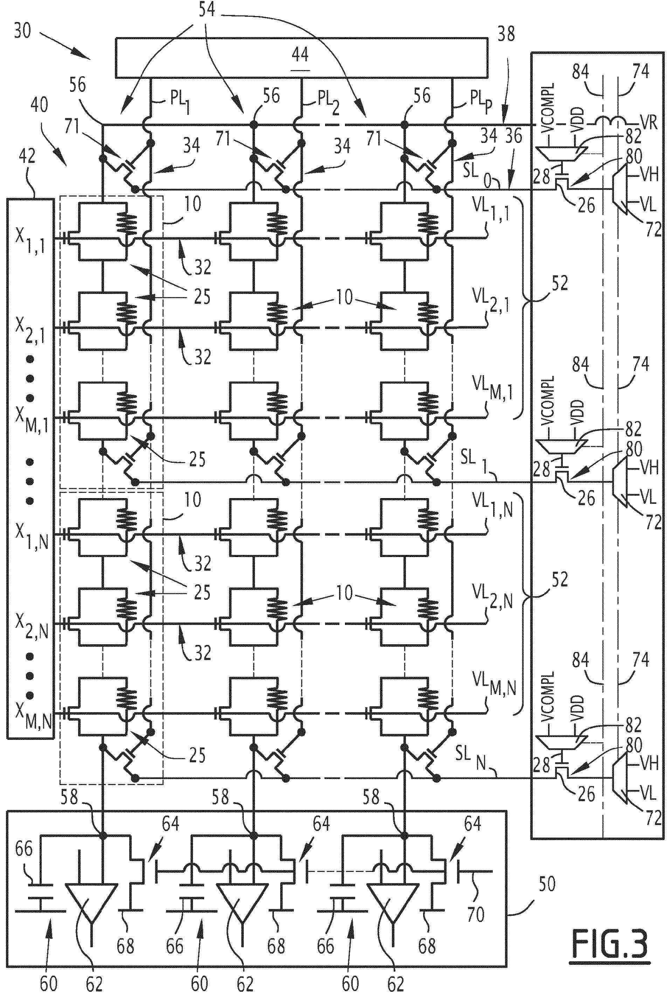

La figure 3 illustre une variante de réalisation du circuit électronique 30 de la figure 2, pour laquelle les éléments communs avec le circuit électronique 30 de la figure 2 sont repérés par des références identiques, et ne sont pas décrits à nouveau.

Selon cette variante de réalisation, le circuit électronique 30 comprend en outre des commutateurs auxiliaires 80, chaque ligne de source 36 étant connectée à un commutateur auxiliaire 80 respectif.

Chaque commutateur auxiliaire 80 est configuré pour, en cas de réception d'une commande de limitation, limiter un courant électrique circulant dans la ligne de source 36 associée. Cette limitation du courant électrique dans la ligne de source 36 correspondante est typiquement mise en œuvre lors d'une opération de programmation, afin de limiter le courant dans l'au moins une cellule mémoire 10 à programmer, et en particulier dans le ou les memristors 20 associés.

Chaque commutateur auxiliaire 80 est également appelé interrupteur auxiliaire. Chaque commutateur auxiliaire 80 est par exemple réalisé sous forme du transistor 26, le transistor 26 étant de préférence alors un transistor à effet de champ. La commande de limitation est alors typiquement un potentiel prédéfini de limitation VCOMPL appliqué à l'électrode de commande 28 dudit commutateur auxiliaire 80.

Comme connu en soi, le courant traversant le transistor à effet de champ entre les électrodes de conduction 27 est - en régime de saturation du transistor à effet de champ, en particulier du transistor MOSFET - limité à une valeur maximale dépendant d'une tension $V_{GS}$ entre l'électrode de source S et l'électrode de grille G, et plus la tension $V_{GS}$ est faible, plus ladite valeur maximale de courant est également faible.

Selon cette variante de réalisation, l'homme du métier comprendra alors que la limitation du courant circulant à travers la ligne de source 36 correspondante est obtenue par application à l'électrode de commande 28 du commutateur auxiliaire 80 du potentiel prédéfini de limitation VCOMPL, de valeur inférieure à celle d'un potentiel par défaut VDD, le potentiel par défaut VDD correspondant à une absence de limitation de courant.

Chaque commutateur auxiliaire 80 est typiquement connecté entre une extrémité de la ligne de source 36 respective et un multiplexeur 72 respectif. Autrement dit, chaque commutateur auxiliaire 80 est agencé entre l'ensemble 40 de cellules mémoire et un multiplexeur 72 respectif. Chaque commutateur auxiliaire 80 est de préférence inclus dans le troisième contrôleur 46.

Selon cette variante de réalisation, et en complément facultatif, le circuit électronique 30 comprend en outre des multiplexeurs auxiliaires 82 et un bus de sélection auxiliaire 84 connecté aux multiplexeurs auxiliaires 82. L'électrode de commande 28 de chaque commutateur auxiliaire 80 est alors connectée à un multiplexeur auxiliaire 82 respectif, chaque multiplexeur auxiliaire 82 étant configuré pour sélectionner - en fonction d'un signal de limitation et parmi plusieurs valeurs prédéfinies, telles que la valeur du potentiel prédéfini de limitation VCOMPL et celle du potentiel par défaut VDD - une valeur de potentiel électrique à appliquer à l'électrode de commande 28 associée.

Les figures 4 à 6 illustrent le cas particulier du premier mode de réalisation où le nombre M de memristor(s) 20 par cellule mémoire 10 est égal à 1, pour lequel les éléments analogues à ceux du cas général décrit précédemment (où le nombre M est supérieur ou égal à 1, et notamment strictement supérieur à 1) sont repérés par des références identiques, et ne sont pas décrits à nouveau.

Dans l'exemple de la figure 4, la cellule mémoire 10 comprend le memristor 20 connecté entre les deux bornes principales 12, 14 ; le commutateur primaire 22 connecté entre les deux bornes principales 12, 14, en parallèle du memristor 20 ; et le commutateur secondaire 24 connecté entre la deuxième borne principale 14 et la borne auxiliaire 16.

Dans cet exemple, la cellule mémoire 10 comprend alors un seul memristor 20. La cellule mémoire 10 comprend exactement deux commutateurs 22, 24. Autrement dit, la cellule mémoire 10 comprend une seule sous-cellule 25.

Dans l'exemple de la figure 4, la cellule mémoire 10 est alors constituée des première et deuxième bornes principales 12, 14, de la borne auxiliaire 16, du memristor 20, et des commutateurs primaire et secondaire 22, 24.

Dans cet exemple, la cellule mémoire 10 est donc une cellule mémoire de type 2T1R, en référence à la présence de deux commutateurs (appellation 2T) et d'un seul memristor (appellation 1R).

L'homme du métier observera alors que la cellule mémoire 10 de l'exemple de la figure 4 comporte un memristor en moins que la cellule mémoire de type 2T2R de l'état de la technique.

Dans l'exemple de la figure 4, le transistor 26 formant le commutateur primaire 22 est alors connecté par son électrode de source S à la première borne principale 12 et par son électrode de drain D à la deuxième borne principale 14. Le transistor 26 formant le commutateur secondaire 24 est connecté par son électrode de source S à la deuxième borne principale 14 et par son électrode de drain D à la borne auxiliaire 16.

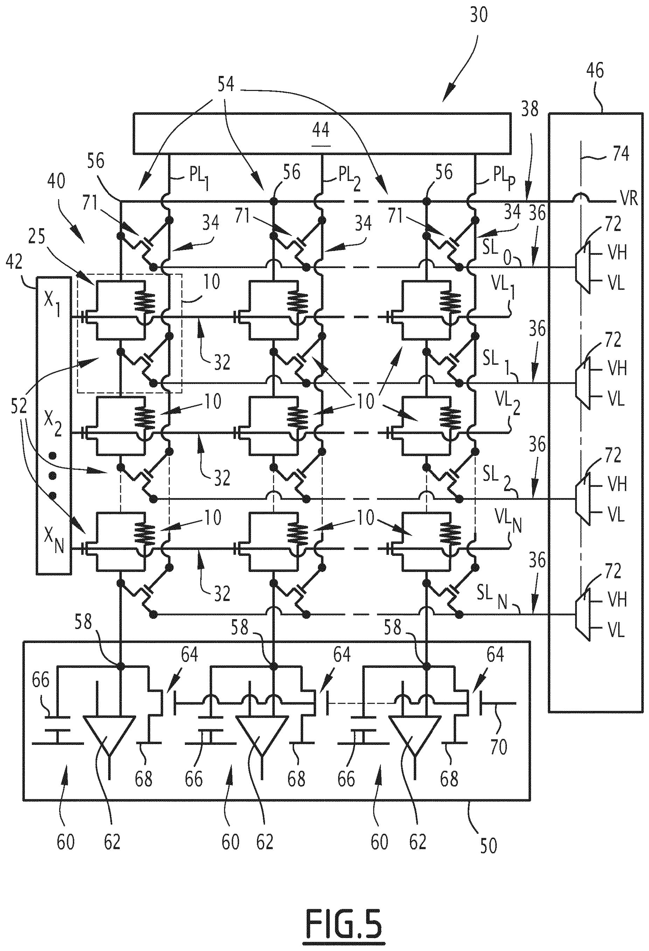

Dans l'exemple de la figure 5, le circuit électronique 30 est analogue à celui de la figure 2 en ayant alors le nombre M égal à 1, et comprend également les lignes de valeur 32, les lignes de programmation 34, les lignes de source 36 et l'ensemble 40 de cellules mémoire 10, chaque cellule mémoire 10 étant telle que représentée à la figure 4.

Dans cet exemple de la figure 5, le nombre M étant égal à 1, l'indice i n'est pas nécessaire. Les lignes de valeur 32 sont également notées $VL_k$ avec k l'indice entier variant de 1 à N, où N représente le nombre de rangées 52. Plus précisément, les lignes de valeur 32 sont alors notées $VL_1$, $VL_2$, ..., $VL_N$.

Dans l'exemple de la figure 5, l'ensemble 40 comprend typiquement entre 32 et 2 000 cellules mémoire 10, et de préférence de quelques centaines à environ 1000 cellules mémoire 10.

Les lignes de programmation 34 sont également notées $PL_j$, avec j l'indice entier variant de 1 à P, où P représente le nombre de colonnes 54. Les lignes de programmation 34 sont alors notées $PL_1$, $PL_2$, ..., $PL_P$.

Les lignes de source 36 sont également notées $SL_k$, avec k l'indice entier variant de 1 à N, où N représente le nombre de rangées 52. Les lignes de source 36 sont alors notées $SL_1$, $SL_2$, ..., $SL_N$.

En complément, le circuit électronique 30 comprend la ligne de source 36 supplémentaire, notée $SL_0$, permettant d'appliquer le potentiel prédéfini aux premières bornes principales 12 des cellules mémoire 10 de la première rangée de l'ensemble 40 lors de leur programmation.

Dans l'exemple de la figure 5, en complément, le circuit électronique 30 comprend la ligne de référence 38 à laquelle est appliquée le potentiel de référence VR.

En complément, le circuit électronique 30 comprend le premier contrôleur 42, le deuxième contrôleur 44 et le troisième contrôleur 46. En complément encore, le circuit électronique 30 comprend le dispositif de mesure 50.

Le multiple respectif pour chaque ligne de valeur 32 est également noté $X_k$, avec k l'indice entier variant de 1 à N. De manière analogue à ce qui a été décrit ci-dessus pour les lignes de valeur 32, les multiples sont alors notés $X_1$, $X_2$, ..., $X_N$.

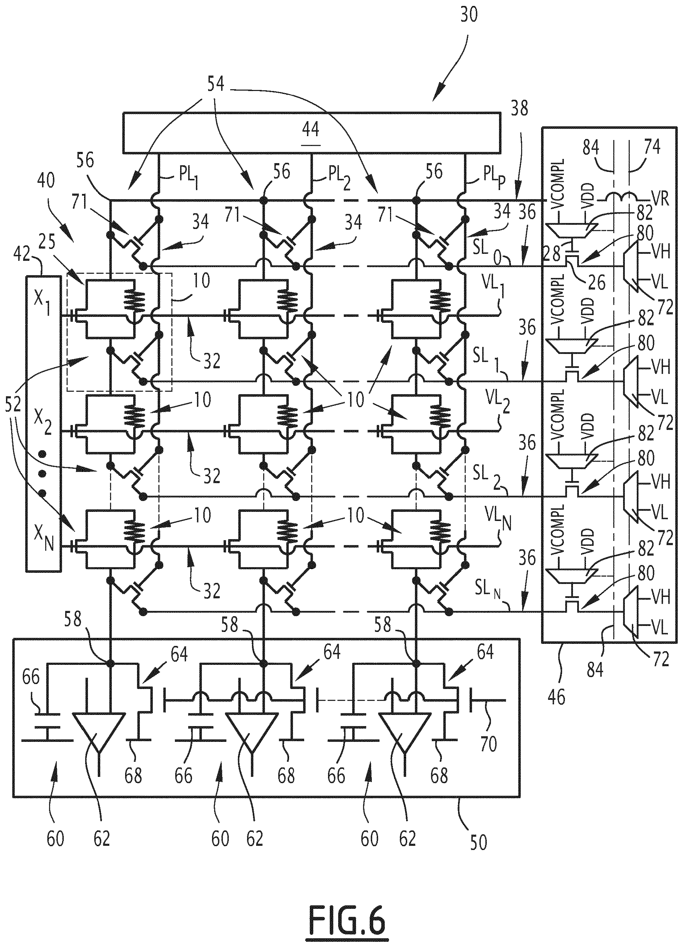

La figure 6 illustre une variante de réalisation du circuit électronique 30 de la figure 5, pour laquelle les éléments communs avec le circuit électronique 30 de la figure 5 sont repérés par des références identiques, et ne sont pas décrits à nouveau.

Cette variante de réalisation est similaire à la variante du circuit électronique 30 de la figure 3 par rapport à celui de la figure 2. Selon cette variante de réalisation, le circuit électronique 30 comprend alors en outre les commutateurs auxiliaires 80, chaque ligne de source 36 étant connectée à un commutateur auxiliaire 80 respectif.

Selon cette variante de réalisation, et en complément facultatif, le circuit électronique 30 comprend en outre les multiplexeurs auxiliaires 82 et le bus de sélection auxiliaire 84 connecté aux multiplexeurs auxiliaires 82.

Le fonctionnement de la cellule mémoire 10 selon l'invention, ainsi que du circuit électronique 30, va être à présent décrit en regard de la figure 8 représentant un organigramme du procédé, selon l'invention, de programmation d'au moins une cellule mémoire 10 d'une rangée 52 respective de cellules mémoire 10 du circuit électronique 30 ; puis en regard de la figure 9 représentant un organigramme du procédé, selon l'invention, de multiplication et accumulation d'un lot de cellule(s) mémoire 10 d'une colonne 54 respective de cellules mémoire 10 du circuit électronique 30.

Sur la figure 8, le procédé de programmation comprend, lors d'une étape initiale 100, l'ouverture des commutateurs primaires 22 des cellules mémoire 10 de la rangée 52 faisant l'objet de cette programmation, via l'application d'une commande d'ouverture sur une ligne de valeur 32 respective connectée à ladite rangée 52.

Lors de cette étape d'ouverture 100, le premier contrôleur 42 commande alors l'ouverture des commutateurs primaires 22 connectés par leur électrode de commande 28 à cette ligne de valeur 32 respective de ladite rangée 52.

L'homme du métier comprendra alors que la ligne de valeur 32 respective, sur laquelle le signal d'ouverture est appliqué, est celle associée au memristor 20 qui est à programmer parmi le ou les memristors 20 de chaque cellule mémoire 10 de ladite rangée 52. En effet, pour la programmation d'un memristor 20 respectif, le commutateur primaire 22 connecté en parallèle de celui-ci doit être ouvert, afin que ledit memristor 20 ne soit pas court-circuité et qu'il puisse avoir une différence de potentiel à ses extrémités.

Le procédé comprend ensuite, lors d'une étape suivante 105, la fermeture d'éventuels autres commutateurs primaires 22 des cellules mémoire 10 de ladite rangée 52, via l'application d'une commande de fermeture sur la ou les éventuelles autres lignes de valeur 32 connectées à ladite rangée 52.

Comme expliqué précédemment, le cas de ces éventuels autres commutateurs primaires 22 à fermer dépend de la valeur du nombre M.

Lorsque le nombre M est strictement supérieur à 1, l'écriture d'une valeur donnée dans un memristor 20 respectif est obtenue notamment via l'ouverture 100 du commutateur primaire 22 en parallèle dudit memristor 20, et la fermeture 105 du ou des M-1 autre(s) commutateur(s) primaire(s) 22, ce qui correspond alors au cas où d'éventuel(s) autre(s) commutateur(s) primaire(s) 22 sont à fermer.

En variante, lorsque le nombre M est égal à 1, l'écriture d'une valeur donnée dans le memristor 20 de la cellule mémoire 10 est obtenue notamment via l'ouverture 100 du commutateur primaire 22 qui est agencé en parallèle dudit memristor 20, et il n'y a alors aucun éventuel autre commutateur primaire 22 à fermer dans ce cas. Autrement dit, l'homme du métier comprendra que lorsque le nombre M est égal à 1, l'étape de fermeture 105 n'est pas effectuée, aucun éventuel autre commutateur primaire 22 n'étant à fermer.

Le procédé de programmation comprend ensuite, lors de l'étape 110, la fermeture de l'au moins un commutateur secondaire 24 de ladite au moins une cellule mémoire 10, via l'application d'une commande de fermeture sur l'au moins une ligne de programmation 34 connectée à ladite au moins une cellule mémoire 10 de ladite rangée 52.

Lors de cette étape de fermeture 110, le deuxième contrôleur 44 commande alors la fermeture du commutateur secondaire 24 de chaque cellule mémoire 10 à programmer au sein de ladite rangée 52.

A l'issue de l'ouverture 100 des commutateurs primaires 22, de la fermeture 105 du ou des éventuels autres commutateurs primaires 22, et de la fermeture 110 de l'au moins un commutateur secondaire 24, le procédé comprend, lors de l'étape suivante 120, l'assignation d'une valeur à l'au moins un memristor 20 de ladite au moins une cellule mémoire 10, avec une tension de programmation correspondant à la valeur entre l'au moins une première borne principale 12 et l'au moins une borne auxiliaire 16 de ladite au moins une cellule mémoire 10.

Lors de cette étape d'assignation 120, le troisième contrôleur 46 applique alors le premier potentiel électrique V1 au(x) ligne(s) de source 36 agencée(s) du côté de l'au moins une première borne principale 12, et respectivement le deuxième potentiel électrique V2 au(x) autre(s) ligne(s) de source 36, agencée(s) du côté l'au moins une borne auxiliaire 16, la tension de programmation correspondant à la valeur assignée étant égale à la différence entre les premier V1 et deuxième V2 potentiels.

L'homme du métier comprendra alors que pour assigner l'état bas LRS au(x) memristor(s) 20 qui sont programmés, cette assignation de l'état bas LRS correspondant à l'opération SET, le troisième contrôleur 46 sélectionne une valeur plus élevée, telle que la valeur VH, pour le premier potentiel que celle sélectionnée pour le deuxième potentiel, telle que la valeur VL, avec VH supérieur à VL par convention, la tension appliquée au(x) memristor(s) 20 étant alors égale à VH-VL.

Inversement, pour assigner l'état haut HRS au(x) memristor(s) 20 qui sont programmés, cette assignation de l'état haut HRS correspondant à l'opération RESET, le troisième contrôleur 46 sélectionne une valeur plus faible, telle que la valeur VL, pour le premier potentiel que celle sélectionnée pour le deuxième potentiel, telle que la valeur VH, avec VH > VL, la tension appliquée au(x) memristor(s) 20 étant alors égale à VL-VH.

Pour la programmation de chaque memristor 20, la tension de programmation est typiquement égale à environ 2 volts, et la valeur VH est par exemple égale à environ 2 volts, pendant que la valeur VL est sensiblement nulle.

Pour la lecture de chaque memristor 20, la tension de lecture est plus faible et typiquement comprise entre environ 0,1 et 0,4 volt, et la valeur VH est par exemple comprise entre environ 0,1 et 0,4 volt, pendant que la valeur VL est sensiblement nulle.

Par convention encore, une résistance plus faible du memristor 20 correspondant son état bas LRS est associée à une valeur plus faible que celle associée à une résistance plus élevée du memristor 20 correspondant son état haut HRS. À titre d'exemple, l'état bas LRS du memristor 20 correspond à un poids faible, c'est-à-dire un « 0 » logique ; et l'état haut HRS du memristor 20 correspond à un poids fort, c'est-à-dire un « 1 » logique.

En complément, plusieurs niveaux distincts de l'état bas LRS et/ou de l'état haut HRS sont utilisés, afin d'avoir plus de deux valeurs de programmation possibles pour le memristor 20. La pluralité de niveaux distincts est de préférence associée à l'état bas LRS, celui-ci étant plus facilement contrôlable que l'état haut HRS.

L'homme du métier comprendra alors que pour assigner, via l'opération SET, l'état bas LRS à l'un des memristors 20 de la cellule mémoire 10 encadrée en trait pointillé de la rangée 52 d'indice égal à 1 dans l'exemple de la figure 2 ou au memristor 20 de la cellule mémoire 10 encadrée en trait pointillé dans l'exemple de la figure 5, le premier potentiel de valeur égale à VH est appliqué à la ligne de source supplémentaire $SL_0$, pendant que le deuxième potentiel de valeur égale à VL est appliqué aux lignes de source $SL_,$, $SL_2$, ..., $SL_N$. Inversement, dans cet exemple de la figure 2 ou de la figure 5, pour assigner, via l'opération RESET, l'état haut HRS au memristor 20 précité, la valeur du premier potentiel appliqué à la ligne de source supplémentaire $SL_0$ est égale à VL, pendant que la valeur du deuxième potentiel appliqué aux lignes de source $SL_1$, $SL_2$, ..., $SL_N$ est égale à VH.

Comme décrit précédemment, ce positionnement du potentiel de chacune des lignes de source 36 à l'une ou l'autre valeur est typiquement effectuée en commandant les multiplexeurs 72 de manière correspondante via le positionnement d'un message respectif sur le bus de sélection 74. À titre d'exemple, en supposant qu'un bit de valeur 1 commande la sélection de la valeur VH par le multiplexeur 72, et respectivement qu'un bit de valeur 0 commande la sélection de la valeur VL par ledit multiplexeur 72, et en outre que - pour le message appliqué sur le bus de sélection 74 - le premier bit du message est associé au premier multiplexeur, par convention celui associé la ligne de source supplé-mentaire $SL_0$, et respectivement le dernier bit du message est associé au dernier multiplexeur, par convention celui associé la ligne de source $SL_N$, alors l'état bas LRS est assigné, via l'opération SET, au memristor 20 précité à la figure 2 ou 5 en positionnant le message (1000) sur le bus de sélection 74 ; et inversement l'état haut HRS est assigné, via l'opération RESET, à ce memristor 20 en positionnant le message (0111) sur ledit bus de sélection 74.

En complément facultatif, lorsque le circuit électronique 30 comporte en outre les commutateurs auxiliaires 80, le troisième contrôleur 46 commande en outre, lors de cette étape d'assignation 120, la fermeture des commutateurs auxiliaires 80 connectés aux lignes de source 36 auxquelles l'un des premier V1 et deuxième V2 potentiels est appliqué. Le commutateur auxiliaire 80 associé à la rangée 52 faisant l'objet de la programmation, c'est-à-dire le commutateur auxiliaire 80 connecté à la ligne de source 36 qui est elle-même connectée à l'au moins une borne auxiliaire 16 de ladite rangée 52, est de préférence en outre commandé avec le potentiel prédéfini de limitation VCOMPL appliqué à son électrode de commande 28, afin de limiter le courant circulant à travers chaque memristor 20 lors de sa programmation.

En variante, lorsque le circuit électronique 30 ne comporte pas les commutateurs auxiliaires 80, le commutateur secondaire 24 de chaque cellule mémoire 10 à programmer est de préférence en outre commandé avec le potentiel prédéfini de limitation VCOMPL appliqué à son électrode de commande 28, afin de limiter le courant circulant à travers chaque memristor 20 lors de sa programmation. Selon cette variante, le deuxième contrôleur 44 commande alors, lors de l'étape de fermeture 110, la fermeture du commutateur secondaire 24 de chaque cellule mémoire 10 à programmer, avec le potentiel prédéfini de limitation VCOMPL.

Sur la figure 9, le procédé de multiplication et accumulation comprend, lors d'une étape initiale 200, l'ouverture des commutateurs secondaires 24 des cellules mémoire 10 de la colonne 54 faisant l'objet de cette multiplication et accumulation, via l'application d'une commande d'ouverture sur la ligne de programmation 34 connectée à ladite colonne 54.

Lors de cette étape d'ouverture 200, le deuxième contrôleur 44 commande alors l'ouverture des commutateurs secondaires 24 des cellules mémoire 10 de ladite colonne 54.

Lors de cette étape d'ouverture 200, le deuxième contrôleur 44 commande de préférence encore l'ouverture de tous les commutateurs secondaires 24 du circuit électronique 30. L'homme du métier comprendra en effet que les lignes de source 36 servent à la programmation des cellules mémoire 10, ou encore à la lecture de ces cellules mémoire 10 indépendamment les unes des autres, et ne sont pas utilisées lors de l'inférence des cellules mémoire 10, et en particulier lors de la multiplication et accumulation. L'ouverture de tous les commutateurs secondaires 24 permet alors d'isoler l'ensemble 40 de cellules mémoire 10 par rapport à ces lignes de source 36 lors de la lecture des cellules mémoire 10.

Si le lot de cellule(s) mémoire 10 faisant l'objet de cette multiplication et accumulation n'inclut pas toutes les cellules mémoire 10 de la colonne 54 correspondante, le procédé de multiplication et accumulation comprend alors en outre, lors d'une étape 210, la fermeture de chaque commutateur primaire 22 de chaque cellule mémoire 10 distincte dudit lot au sein de la colonne 54, via l'application d'une commande de fermeture sur chaque ligne de valeur 32 connectée à chaque cellule mémoire 10 distincte dudit lot. Autrement dit, lors de cette étape de fermeture 210, chaque commutateur primaire 22 de chaque cellule mémoire 10 qui n'est pas incluse dans ledit lot, tout en se trouvant au sein de ladite colonne 54, est fermé.

Lors de cette étape de fermeture 210, le premier contrôleur 42 commande alors la fermeture de chaque commutateur primaire 22 pour chaque cellule mémoire 10 de ladite colonne 54 et qui n'est pas incluse dans le lot de cellule(s) mémoire 10 faisant l'objet de la multiplication et accumulation.

A l'issue de l'ouverture des commutateurs secondaires 24 et de la fermeture de chaque commutateur primaire 22 de chaque cellule mémoire 10 qui n'est pas incluse dans ledit lot faisant l'objet de la multiplication et accumulation, le procédé comprend, lors de l'étape suivante 220, le pilotage de chaque commutateur primaire 22 dudit lot de cellule(s) mémoire 10 avec une alternance d'ouverture(s) et de fermeture(s) au cours d'un cycle d'inférence, via l'application de commandes alternées d'ouverture(s) et de fermeture(s) sur chaque ligne de valeur 32 connectée à chaque commutateur primaire 22 dudit lot.

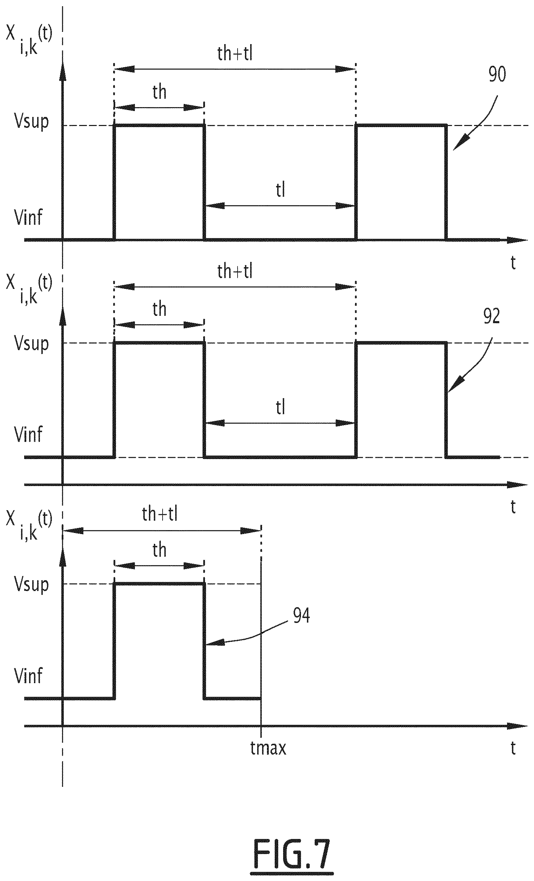

Lors de cette étape de pilotage 220, le premier contrôleur 42 commande alors chaque commutateur primaire 22 de chaque cellule mémoire 10 dudit lot avec un signal de pilotage 90, 92, 94 comportant une alternance entre un potentiel inférieur Vinf correspondant à l'ouverture du commutateur primaire 22 et un potentiel supérieur Vsup correspondant à la fermeture du commutateur primaire 22, comme représenté dans l'exemple de la figure 7.

La durée d'un palier d'ouverture au potentiel inférieur Vinf est notée tl, et la durée d'un palier de fermeture au potentiel supérieur Vsup est notée th. La durée d'une alternance d'ouverture et de fermeture du commutateur primaire 22 est alors égale à th+tl, comme représenté à la figure 7.

Lors de cette étape de pilotage 220, cette alternance d'ouverture(s) et de fermeture(s) du commutateur primaire 22 permet alors de multiplier la valeur de chaque memristor 20 dudit lot par un multiple respectif $X_{i,k}$, où ledit multiple respectif $X_{i,k}$ est fonction du ratio $\rho$ (noté $\rho_i$ pour la rangée 52 d'indice i) entre la durée cumulée d'ouverture du commutateur primaire 22 respectif au cours du cycle d'inférence et la durée dudit cycle. Le ratio $\rho_i$ respectif est associé au multiple $X_{i,k}$, tous deux étant pour la rangée 52 d'indice i.

Cette multiplication par le multiple respectif $X_{i,k}$ est d'autant plus précise que le transistor 26 formant le commutateur primaire 22 est assimilable à un commutateur parfait. Le commutateur primaire 22 est par exemple considéré comme un commutateur parfait si sa résistance à l'état fermé, notée Rf, est très inférieure, typiquement au moins cinq fois inférieure, et de préférence au moins dix fois inférieure, à la résistance du memristor 20, notée Rm ; et si sa résistance à l'état ouvert, notée Ro, est très supérieure, typiquement au moins cinq fois supérieure, et de préférence au moins dix fois supérieure, à ladite résistance Rm du memristor 20. En outre, le temps de transition, noté Tr, entre l'état ouvert et l'état fermé dudit commutateur primaire 22 est préférentiellement très inférieur, typiquement au moins cinq fois inférieur, et de préférence au moins dix fois inférieur, à la durée tl du palier d'ouverture au potentiel inférieur Vinf, et aussi à la durée th du palier de fermeture au potentiel supérieur Vsup. Le commutateur primaire 22 est alors typiquement parfait s'il vérifie les conditions suivantes : Rf << Rm, Ro >> Rm, Tr << th et Tr << tl.

Lorsque le commutateur primaire 22 est assimilable à un tel commutateur parfait, la résistance équivalente R(t) de la sous-cellule 25 de la cellule mémoire 10 correspondante vérifie typiquement l'équation suivante :

[1]

$$R(t) = \big(1 - x(t)\big).Rm$$

où R(t) représente la valeur de la résistance équivalente de la sous-cellule 25 respective, variable au cours du temps t ;
x(t) représente un signal binaire de pilotage du commutateur primaire 22 de la sous-cellule 25, où le potentiel supérieur Vsup correspond alors à la valeur 1, et le potentiel inférieur Vinf correspond à la valeur 0 ; et
Rm représente la valeur de la résistance du memristor 20.

Cette multiplication par le multiple respectif $X_{i,k}$ est également d'autant plus précise que la durée th+tl d'une alternance d'ouverture et de fermeture du commutateur primaire 22 est bien plus faible, typiquement au moins cinq fois plus faible, et de préférence au moins dix fois plus faible, qu'une durée $_\tau$ de charge du condensateur 66 du module de mesure 60 pour ladite colonne 54.

La durée $_\tau$ de charge du condensateur 66 vérifie alors typiquement l'équation suivante :

[2]

$$\tau = (Rs + \rho.Rm).C$$

où $_\tau$ représente la durée de charge du condensateur 66 ;
Rs représente la résistance série des autres sous-cellules 25 de la colonne 54 connectées en série avec la sous-cellule 25 respective pour laquelle le signal de pilotage est appliqué au commutateur primaire 22 ;
$\rho$ représente le ratio entre la durée cumulée d'ouverture du commutateur primaire 22 respectif au cours du cycle d'inférence et la durée dudit cycle ;
Rm représente la valeur de la résistance du memristor 20 de la sous-cellule 25 respective ; et
C représente la capacité du condensateur 66.

Cette multiplication par le multiple respectif $X_{i,k}$ est également d'autant plus précise que la résistance équivalente R(t) de la cellule mémoire 10 correspondante est bien plus faible, typiquement au moins cinq fois plus faible, et de préférence au moins dix fois plus faible, que la résistance série Rs des autres sous-cellules 25 de la colonne 54 connectées en série avec la sous-cellule 25 respective faisant l'objet de l'opération d'inférence.

Pour augmenter la résistance série Rs des autres sous-cellules 25 de la colonne 54 par rapport à la résistance équivalente R(t) d'une sous-cellule 25 respective, le premier contrôleur 42 commande typiquement les ouvertures et fermetures des commutateurs primaires 22 de la colonne 54 avec des instants temporels d'ouverture, et respectivement de fermeture, variables d'une ligne de valeur 32 à l'autre. Autrement dit, l'instant temporel de début du palier d'ouverture au potentiel inférieur Vinf est de préférence distinct d'une ligne de valeur 32 à l'autre ; et de manière analogue l'instant temporel de début du palier de fermeture au potentiel supérieur Vsup est aussi distinct d'une ligne de valeur 32 à l'autre.

En variante, ce décalage entre les instants temporels d'ouverture, et respectivement de fermeture, entre les sous-cellules 25 de la colonne 54 est effectué par sous-lots de sous-cellule(s) 25 au sein de ladite colonne 54. Selon cette variante, les sous-cellules 25 de la colonne 54 sont par exemple réparties en B sous-lots distincts, avec B entier supérieur ou égal à 2. Les instants temporels d'ouverture du ou des commutateurs primaires 22 sont alors identiques pour la ou les sous-cellules 25 d'un même sous-lot, et distincts d'un sous-lot à l'autre. De manière analogue, les instants temporels de fermeture du ou des commutateurs primaires 22 sont identiques pour la ou les sous-cellules 25 d'un même sous-lot, et distincts d'un sous-lot à l'autre.

Le signal de pilotage 90, 92, 94 est de préférence périodique, et lorsque celui-ci comporte plusieurs alternances d'ouverture et de fermeture du commutateur primaire 22, alors la durée de chaque alternance ouverture et de fermeture reste égale à th+tl.

Le ratio ρ entre la durée cumulée d'ouverture du commutateur primaire 22 respectif au cours du cycle d'inférence et la durée dudit cycle vérifie alors typiquement l'équation suivante :

[3]

$$\rho = \frac{tl}{th + tl}$$

où ρ représente ledit ratio ;
tl représente la durée du palier d'ouverture du commutateur primaire 22, th représentant la durée du palier de fermeture dudit commutateur primaire 22 ;
th+tl représentant alors la durée d'une alternance respective d'ouverture et de fermeture du commutateur primaire 22.

Sur la figure 7, différents exemples de signaux 90, 92, 94 de pilotage du commutateur primaire 22 avec cette alternance d'ouverture(s) et de fermeture(s) sont alors représentés.

Un premier signal de pilotage 90 comporte plusieurs alternances d'ouverture et de fermeture du commutateur primaire 22 au cours du cycle, avec en outre le potentiel inférieur Vinf de valeur sensiblement nulle.

En variante, un deuxième signal de pilotage 92 comporte également plusieurs alternances d'ouverture et de fermeture du commutateur primaire 22, avec le potentiel inférieur Vinf de valeur strictement positive selon cette variante. Le fait d'avoir le potentiel inférieur Vinf de valeur strictement positive, et donc non nulle, permet alors une résistance résultante Rcom du commutateur primaire 22 qui n'est pas nulle en position d'ouverture dudit commutateur primaire 22.

Selon cette variante, la résistance équivalente R(t) de la sous-cellule 25 correspondante vérifie typiquement l'équation suivante :

[4]

$$R(t) = \left(1 - x(t)\right) . \frac{Rm . Rcom}{Rm + Rcom}$$

où R(t) représente la valeur de la résistance équivalente de la sous-cellule 25 respective, variable au cours du temps t ;
x(t) représente le signal binaire de pilotage du commutateur primaire 22 de la sous-cellule 25, où la fermeture du commutateur primaire 22 correspond à la valeur 1 et son ouverture correspond à la valeur 0 ;
Rm représente la valeur de la résistance du memristor 20 ;
Rcom représente la résistance résultante du commutateur primaire 22 en position d'ouverture, de par la commande d'ouverture à un potentiel strictement positif.

L'état haut HRS est susceptible de varier sensiblement d'un memristor 20 à l'autre, avec des valeurs de cet état haut HRS variant par exemple entre environ 40 kΩ et 200 kΩ, ce qui peut s'avérer gênant, étant donné que la résistance équivalente R(t) est représentative du multiple respectif, tel qu'un poids synaptique lorsque le circuit électronique 30 est utilisé pour l'inférence d'un réseau de neurones artificiels.

Cette variante avec le potentiel inférieur Vinf de valeur strictement positive permet alors de limiter cette dispersion de valeurs résistives, la valeur de la résistance équivalente R(t) étant alors essentiellement fonction de la résistance résultante Rcom lorsque la valeur de la résistance Rm du memristor 20 est nettement plus élevée que celle de la résistance résultante Rcom, selon l'équation (4). Si la résistance résultante Rcom est par exemple choisie égale à environ 50 kΩ, alors la distribution de valeurs pour le maximum de la résistance équivalente R(t) sera comprise entre environ 25 kΩ et 50 kΩ.

Cette variante avec le potentiel inférieur Vinf de valeur strictement positive permet également une meilleure efficacité de calcul, et notamment d'autoriser un plus grand nombre de sous-cellules 25 connectées en série dans chaque colonne 54, étant donné que la résistance équivalente R(t) de la sous-cellule 25 selon cette variante, par exemple selon l'équation (4), est inférieure à la résistance équivalente R(t) de la sous-cellule 25 obtenue dans le cas du potentiel inférieur Vinf de valeur sensiblement nulle, par exemple selon l'équation (1).

En effet, l'homme du métier observera la relation d'inégalité suivante :

[5]

$$\frac{Rm . Rcom}{Rm + Rcom} < Rm$$

de par l'inégalité suivante :

[6]

$$\frac{Rcom}{Rm + Rcom} < 1$$

Rcom et Rm étant des valeurs strictement positives.

En variante encore, un troisième signal de pilotage 94 comporte une seule alternance d'ouverture et de fermeture du commutateur primaire 22, avec le potentiel inférieur Vinf de valeur strictement positive. La durée tmax du cycle d'inférence selon cette variante est alors égale à la durée th+tl de ladite alternance d'ouverture et de fermeture, c'est-à-dire à la somme de la durée tl du palier d'ouverture et de la durée th du palier de fermeture du commutateur primaire 22.

Cette variante avec une seule alternance d'ouverture et de fermeture du commutateur primaire 22 nécessite alors que la durée tmax soit bien inférieure à la durée $_T$ de charge du condensateur 66 du module de mesure 60 pour ladite colonne 54, ce qui implique qu'un seuil de tension Vth, à atteindre par la tension cumulée des sous-cellules 25 de la colonne 54 pour l'obtention - lors de l'étape suivante 230 - d'une somme pondérée de valeurs de memristors 20 dudit lot, soit bien inférieur, typiquement au moins cinq fois inférieur, et de préférence au moins dix fois inférieur, au potentiel de référence VR permettant de charger le condensateur 66.

Cette variante avec une unique alternance d'ouverture et de fermeture du commutateur primaire 22 permet alors également une meilleure efficacité de calcul, puisque la somme pondérée est alors calculée plus rapidement, en une seule alternance d'ouverture et de fermeture du commutateur primaire 22.

L'homme du métier comprendra alors que parmi les premier 90, deuxième 92 et troisième 94 signaux de pilotage, le troisième signal de pilotage 94 permet d'avoir la plus grande efficacité de calcul, étant donné qu'il offre les deux avantages précités.

Le procédé de multiplication et accumulation comprend ensuite, lors de l'étape 230, l'obtention de la somme pondérée de valeurs de memristors 20 dudit lot via une mesure de la tension cumulée des cellules mémoire 10 de ladite colonne 54, chaque valeur de memristor 20 étant multipliée par le multiple respectif $X_{i,k}$.

Lors de cette étape d'obtention 230, le dispositif de mesure 50 effectue alors la mesure de cette tension cumulée pour ladite colonne 54 via le module de mesure 60 respectif associé à ladite colonne 54, et obtient alors typiquement la somme pondérée via la somme des résistances équivalentes des cellules mémoire 10 de ladite colonne 54 au cours du cycle d'inférence.

Le module de mesure 60 calcule par exemple cette somme pondérée à partir de l'équation (2) précédente, et après avoir déterminé la durée $_T$ de charge du condensateur 66 associé à ladite colonne 54. Pour déterminer cette durée $_T$ de charge du condensateur 66, le module de mesure 60 effectue par exemple une réinitialisation de la charge du condensateur 66 en commandant la fermeture du commutateur de réinitialisation 64 au début de l'étape de pilotage 220, puis détecte l'atteinte du seuil de tension Vth correspondant à la charge du condensateur 66 via le comparateur 62, le comparateur 62 recevant d'une part la tension cumulée progressivement dans la colonne 54 en ayant une entrée connectée à la deuxième extrémité 58 de ladite colonne 54, et recevant d'autre part ledit seuil de tension Vth en ayant son autre entrée connectée à un potentiel égal à ce seuil de tension Vth. Lorsque le seuil de tension Vth est atteint, le module de mesure 60 détermine alors cette durée $_T$ de charge du condensateur 66, en comptabilisant le nombre de cycles d'une horloge interne du comparateur 62 qui se sont écoulés entre l'instant de réinitialisation du condensateur 66 au début de l'étape de pilotage 220 et la détection de l'atteinte dudit seuil de tension Vth.

En complément facultatif, l'homme du métier observera en outre que le dispositif de mesure 50 est configuré en outre pour obtenir les sommes pondérées pour plusieurs colonnes 54 à la fois, et de préférence pour toutes les colonnes 54 à la fois du circuit électronique 30.

Selon ce complément, l'obtention simultanée des sommes pondérées pour plusieurs colonnes 54 est effectuée à l'aide de l'équation suivante :

[7]

$$\begin{pmatrix} \tau_1 \\ \vdots \\ \tau_j \\ \vdots \\ \tau_P \end{pmatrix} = C . \begin{pmatrix} R_{1,1} & \dots & R_{1,l} & \dots & R_{1,N} \\ \vdots & \ddots & & & \vdots \\ R_{j,1} & & R_{j,l} & & R_{j,N} \\ \vdots & & & \ddots & \vdots \\ R_{P,1} & \dots & R_{P,l} & \dots & R_{P,N} \end{pmatrix} . \begin{pmatrix} X_1 \\ \vdots \\ X_l \\ \vdots \\ X_N \end{pmatrix}$$

où l est un indice entier associé aux lignes de valeur 32, c'est-à-dire aux sous-cellules 25 de chaque colonne 54 respective, et variant de 1 à MxN, où M représente le nombre de sous-cellules 25 par cellule mémoire 10 et N représente le nombre de rangées 52 de l'ensemble 40 de cellules mémoire 10,

j est l'indice entier associé aux colonnes 54 et variant de 1 à P, où P représente le nombre de colonnes 54 dudit ensemble 40,

$T_j$ représente la durée de charge du condensateur 66 associé à la colonne d'indice j,

C représente la capacité du condensateur 66, celle-ci étant identique d'une colonne 54 à l'autre dans l'exemple de l'équation (7),

$R_{j,l}$ représente la valeur de résistance du memristor 20 de la sous-cellule 25 appartenant à la colonne d'indice j et associée à la ligne de valeur d'indice l, et

$X_l$ représente la valeur multiplicative appliquée sur la ligne de valeur 32 d'indice l ;

avec en outre par convention :

[8]

$$\begin{pmatrix} X_1 \\ \vdots \\ X_l \\ \vdots \\ X_N \end{pmatrix} = \begin{pmatrix} \left(\dfrac{tl}{th+tl}\right)_1 \\ \vdots \\ \left(\dfrac{tl}{th+tl}\right)_l \\ \vdots \\ \left(\dfrac{tl}{th+tl}\right)_N \end{pmatrix} = \begin{pmatrix} \rho_1 \\ \vdots \\ \rho_l \\ \vdots \\ \rho_N \end{pmatrix}$$

où $X_l$ représente la valeur multiplicative appliquée sur la ligne de valeur 32 d'indice l,

tl représente la durée du palier d'ouverture du commutateur primaire 22 associé à la ligne de valeur d'indice l, et

th+tl représente la durée d'une alternance respective d'ouverture et de fermeture du commutateur primaire 22 associé à la ligne de valeur d'indice l ;

$\rho_i$ représentant subsidiairement le ratio respectif pour la ligne de valeur d'indice l.

L'homme du métier observera que l'indice l représentatif d'une ligne de valeur 32 respective correspond au couple (i,k) d'indices i et k, définis précédemment, et que l'indice l est utilisé préférentiellement au couple (i,k) dans les équations (7) et (8) précédentes, afin d'éviter d'avoir des notations avec trop d'indices, notamment pour la valeur de la résistance du memristor 20.

L'homme du métier comprendra alors que la cellule mémoire 10 selon l'invention autorise l'écriture, puis la lecture et/ou l'inférence, de n'importe quelle valeur, sous forme de la valeur de la résistance électrique du memristor 20 inclus dans chaque sous-cellule 25 de la cellule mémoire 10, et pas seulement d'une valeur binaire à la différence de la cellule mémoire de l'état de la technique.

En outre, chaque sous-cellule 25 permet la multiplication d'une valeur du memristor 20 par un multiple $X_{i,k}$ respectif, via l'alternance d'ouverture(s) et de fermeture(s) du commutateur primaire 22 au cours d'un cycle d'inférence, comme expliqué ci-dessus.

L'homme du métier observera en outre que le multiple $X_{i,k}$ respectif est susceptible de prendre n'importe quelle valeur, et n'est également pas limité à une valeur binaire. Dans l'exemple de l'équation (8) précédente, le multiple $X_{i,k}$ respectif est un nombre réel compris entre 0 et 1.

L'homme du métier notera également que le circuit électronique 30 selon l'invention permet en outre la mise en œuvre de l'opération de multiplication et accumulation MAC d'une manière particulièrement efficace, notamment avec les différents gains en efficacité de calcul décrits précédemment.

Le circuit électronique 30 selon l'invention offre en outre une mise en œuvre possible de l'opération MAC pour plusieurs colonnes 54 à la fois, par exemple via la mise en œuvre de l'équation (7) précédente. Lors de l'inférence d'un réseau de neurones artificiels, cela permet alors d'enchaîner les calculs de sommes pondérées pour plusieurs couches successives du réseau de neurones, sans attendre par exemple la fin de l'opération MAC pour une couche précédente du réseau.

Chaque sous-cellule 25 présente en outre un encombrement réduit par rapport à la cellule mémoire de l'état de la technique, chaque sous-cellule 25 comportant un memristor et un commutateur en moins que la cellule mémoire de type 2T2R de l'état de la technique, la sous-cellule 25 selon le premier mode de réalisation de l'invention étant de type 1T1R.

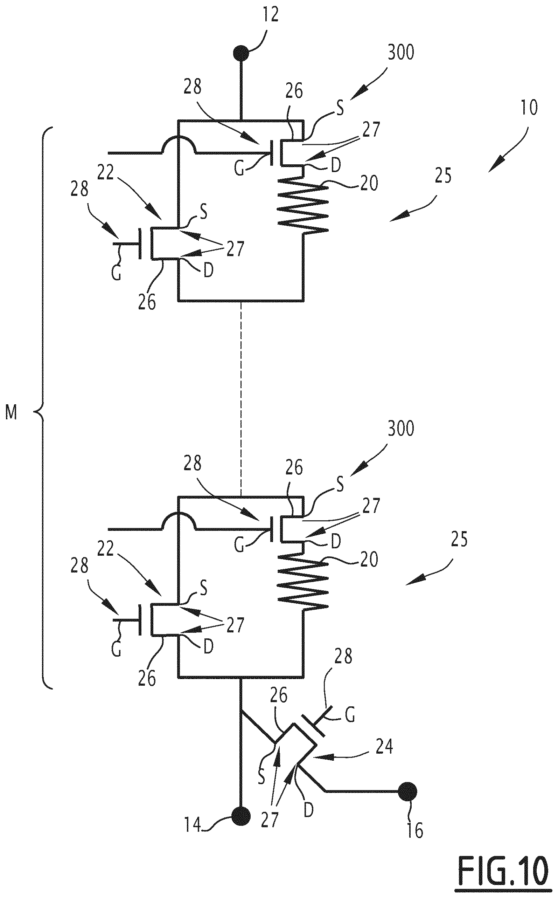

Les figures 10 à 13 illustrent un deuxième mode de réalisation pour lequel les éléments analogues à ceux du premier mode de réalisation décrit précédemment, sont repérés par des références identiques, et ne sont pas décrits à nouveau.

Selon le deuxième mode de réalisation, la cellule mémoire 10 comprend en outre M commutateur(s) tertiaire(s) 300, chacun étant connecté à un memristor 20 respectif, le commutateur tertiaire 300 et le memristor 20 étant connectés en série, en parallèle du commutateur primaire 22 associé.

Dans l'exemple de la figure 10, la cellule mémoire 10 comprend exactement M memristor(s) 20.

Dans l'exemple de la figure 10, la cellule mémoire 10 comprend exactement 2M+1 commutateurs 22, 24, 300.

Dans l'exemple de la figure 10, la cellule mémoire 10 est alors constituée des première et deuxième bornes principales 12, 14, de la borne auxiliaire 16, du memristor 20, et des commutateurs primaire(s), secondaire et tertiaire(s) 22, 24, 300.

Dans l'exemple de la figure 10, la cellule mémoire 10 est donc une cellule mémoire de type (2M+1)TMR, en référence à la présence de 2M+1 commutateurs (appellation (2M+1)T) et de M memristor(s) (appellation MR), et chaque sous-cellule 25 est de type 2T1R.

Dans l'exemple de la figure 10, le nombre entier M est strictement supérieur à 1.

Lorsque le nombre M est strictement supérieur à 1, l'homme du métier comprendra que l'écriture d'une valeur donnée dans un memristor 20 respectif est obtenue notamment via l'ouverture du commutateur primaire 22 en parallèle dudit memristor 20, et la fermeture du ou des M-1 autre(s) commutateur(s) primaire(s) 22, ce qui correspond alors au cas où d'éventuel(s) autre(s) commutateur(s) primaire(s) 22 sont à fermer. Selon ce deuxième mode de réalisation, l'écriture de la valeur donnée dans le memristor 20 respectif est obtenue en outre via la fermeture du commutateur tertiaire 300 en série dudit memristor 20.

Lorsque le nombre M est en variante égal à 1, l'homme du métier comprendra également que l'écriture d'une valeur donnée dans le memristor 20 de la cellule mémoire 10 est obtenue notamment via l'ouverture du commutateur primaire 22 qui est agencé en parallèle dudit memristor 20, la fermeture du commutateur tertiaire 300 en série dudit memristor 20, et qu'il n'y a alors aucun éventuel autre commutateur primaire 22 à fermer dans ce cas.

L'homme du métier observera alors que la cellule mémoire 10 selon l'invention est une cellule de type 3T1R dans le cas où M est égal à 1, et comporte alors un memristor en moins que la cellule mémoire de type 2T2R de l'état de la technique.

L'homme du métier notera plus généralement que dans l'exemple de la figure 10, pour M supérieur à 1, la cellule mémoire 10 de type (2M+1)TMR selon l'invention permet d'écrire M valeurs distincte(s), puis de lire et/ou inférer ces valeurs, chacune des M sous-cellules 25 étant associée à une valeur respective ; et que la cellule mémoire 10 est donc comparable à M cellules mémoire de type 2T2R de l'état de la technique, chaque sous-cellule 25 de type 2T1R selon l'invention étant comparable à la cellule mémoire de type 2T2R de l'état de la technique. L'homme du métier comprendra alors que la cellule mémoire 10 selon l'invention comporte M memristors en moins que les M cellules mémoire de type 2T2R correspondantes de l'état de la technique, ou encore que chaque sous-cellule 25 de type 2T1R selon l'invention comporte un memristor en moins que la cellule mémoire de type 2T2R de l'état de la technique.

Le commutateur tertiaire 300 est également appelé interrupteur tertiaire. Le commutateur tertiaire 300 est par exemple réalisé sous forme du transistor 26. Il comporte, comme connu en soi, les deux électrodes de conduction 27 et l'électrode de commande 28.

Dans l'exemple de la figure 10, le transistor 26 formant le commutateur tertiaire 300 d'une première sous-cellule 25 connectée directement à la première borne principale 12 est connecté par son électrode de source S à ladite première borne principale 12, et par son électrode de drain D au memristor 20 de ladite première sous-cellule 25. Le transistor 26 formant le commutateur tertiaire 300 d'une sous-cellule 25 respective de la série est connecté par son électrode de source S à la sous-cellule 25 précédente, en particulier à l'électrode de drain D du transistor 26 formant le commutateur primaire 22 de ladite sous-cellule 25 précédente ; et respectivement par son électrode de drain D au memristor 20 de la sous-cellule 25 respective. Le transistor 26 formant le commutateur tertiaire 300 de la dernière sous-cellule 25 connectée directement à la deuxième borne principale 14 est connecté par son électrode de source S à la sous-cellule 25 précédente, et par son électrode de drain D au memristor 20 de ladite dernière sous-cellule 25.

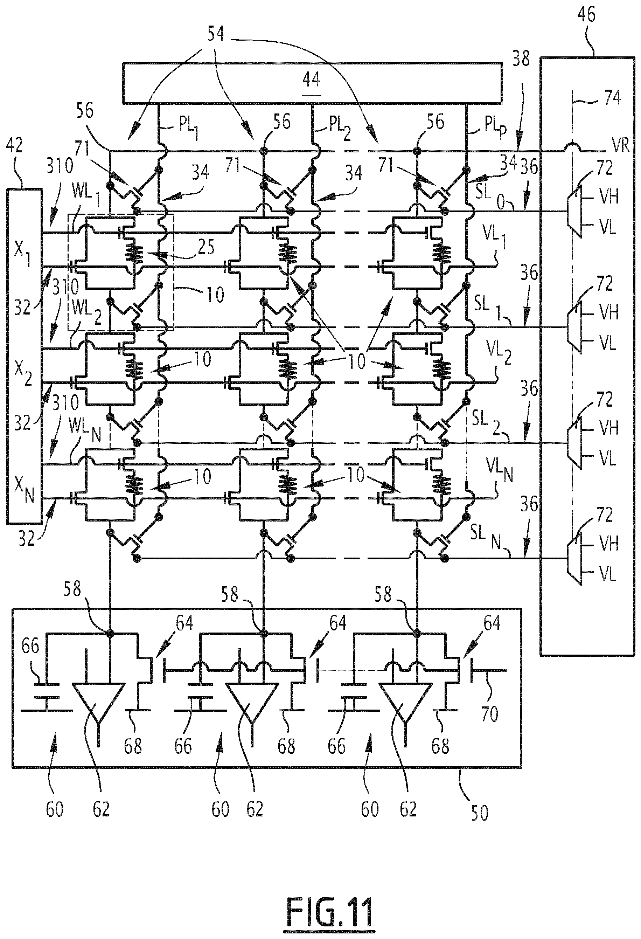

Selon le deuxième mode de réalisation, le circuit électronique 30 comprend en outre des lignes de programmation complémentaire 310, comme représenté sur la figure 11. Pour chaque cellule mémoire 10, l'électrode de commande 28 de chaque commutateur tertiaire 300 est connectée à une ligne de programmation complémentaire 310 respective.

Selon ce deuxième mode de réalisation, l'ensemble 40 de cellules mémoire 10 est de manière analogue typiquement agencé sous forme de la matrice comportant les rangées 52 et les colonnes 54.

Les lignes de programmation complémentaire 310 sont également notées $WL_{i,k}$ avec i l'indice entier variant de 1 à M où M représente le nombre de memristors 20 dans chaque cellule mémoire 10, qui est égal au nombre de commutateurs tertiaires 300 dans chaque cellule mémoire 10, M représentant alors aussi le nombre de commutateurs tertiaires 300 au sein de chaque cellule mémoire 10 ; et k l'indice entier variant de 1 à N, où N représente le nombre de rangées 52. Plus précisément, les lignes de programmation complémentaire 310 sont alors notées $WL_{1,1}$, $WL_{2,1}$, ..., $WL_{M,1}$ pour la première rangée 52 d'indice k égal à 1 ; puis $WL_{1,2}$, $WL_{2,2}$, ..., $WL_{M,2}$ pour la deuxième rangée 52 d'indice k égal à 2 ; jusqu'à $WL_{1,N}$, $WL_{2,N}$, ..., $WL_{M,N}$ pour la dernière rangée 52 d'indice k égal à N.

Dans l'exemple de la figure 11, le nombre M est égal à 1, et l'indice i n'est pas nécessaire. Les lignes de programmation complémentaire 310 sont également notées $WL_k$ avec k l'indice entier variant de 1 à N, où N représente le nombre de rangées 52. Plus précisément, les lignes de programmation complémentaire 310 sont alors notées $WL_1$, $WL_2$, ..., $WL_N$.

De manière analogue à ce qui a été décrit précédemment pour le premier mode de réalisation, l'homme du métier comprendra également qu'en pratique l'ensemble 40 comporte un nombre bien plus important de cellules mémoire 10, que celui dans l'exemple de la figure 11 où le nombre de cellules mémoire 10 représentées est limité par souci de simplification du dessin.

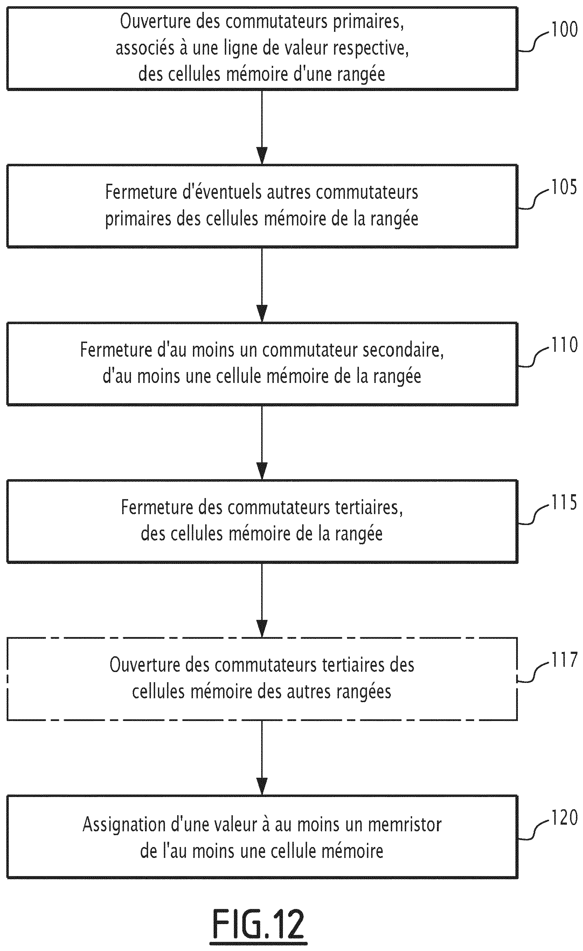

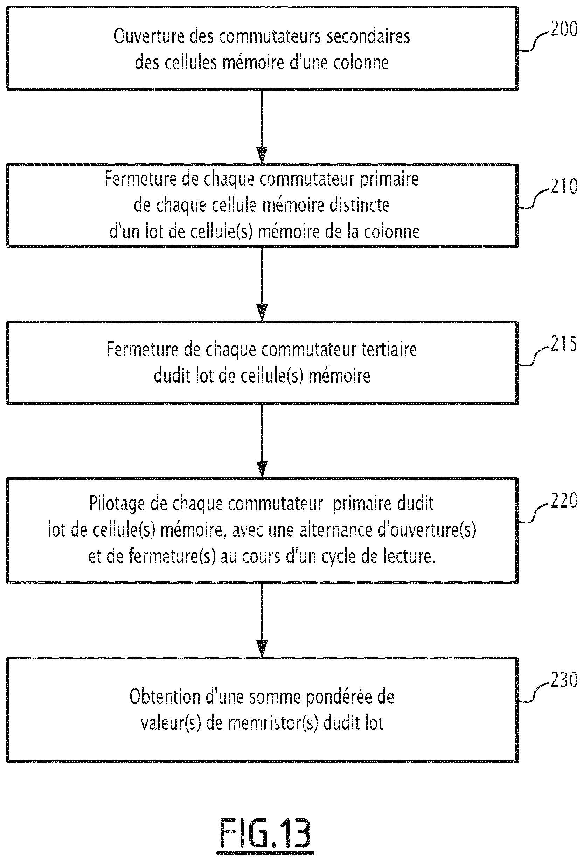

Selon le deuxième mode de réalisation, le premier contrôleur 42 est configuré pour contrôler en outre chacune des lignes de programmation complémentaire 310 connectées aux électrodes de commande 28 des commutateurs tertiaires 300 de l'ensemble 40 de cellules mémoire, en fonction de l'opération effectuée sur les cellules mémoire 10, notamment parmi l'opération de programmation lorsque le procédé de programmation est mis en œuvre, et respectivement l'opération d'inférence lorsque le procédé de multiplication et accumulation est mis en œuvre, ainsi que cela sera décrit plus en détail par la suite en regard de la figure 12, et respectivement de la figure 13 ; ainsi que l'opération de lecture lorsque le procédé de lecture selon l'invention est mis en œuvre.

Le premier contrôleur 42 est par exemple configuré en outre pour commander la fermeture des commutateurs tertiaires 300 d'une rangée 52 respective, lors de la programmation de cellule(s) mémoire 10 de ladite rangée 52.

En variante, le premier contrôleur 42 est configuré pour commander la fermeture des commutateurs tertiaires 300 connectés à une ligne de programmation complémentaire 310 respective associée à ladite rangée et l'ouverture des éventuels autres commutateurs tertiaires 300 des cellules mémoire 10 de ladite rangée 52, ces éventuels autres commutateurs tertiaires 300 étant alors connectés à d'autres lignes de programmation complémentaire 310 que celle à laquelle un signal de fermeture est appliqué.

L'homme du métier observera alors que cette variante permet de fermer seulement le commutateur tertiaire 300 de la sous-cellule 25 faisant l'objet de la programmation et d'ouvrir les éventuels autres commutateurs tertiaires 300 de la cellule mémoire 10. L'homme du métier comprendra alors bien entendu que la ligne de programmation complémentaire 310 à laquelle est appliquée le signal de fermeture est celle associée à la sous-cellule 25 qui est elle-même associée à la ligne de valeur 32 à laquelle le signal d'ouverture est appliqué, étant donné que la programmation d'une sous-cellule 25 respective requiert à la fois l'ouverture du commutateur primaire 22 et la fermeture du commutateur tertiaire 300 de ladite sous-cellule 25.

En complément facultatif, le premier contrôleur 42 est configuré en outre pour commander l'ouverture des commutateurs tertiaires 300 de la ou des rangées autres que la rangée 52 respective faisant l'objet de la programmation de cellule(s) mémoire 10.

Le premier contrôleur 42 est par exemple configuré, lors de la mise en œuvre d'une opération d'inférence avec un lot de cellule(s) mémoire 10 d'une colonne 54 respective, pour commander la fermeture du ou des commutateurs tertiaires 300 dudit lot de cellule(s) mémoire 10 de la colonne 54.

L'homme du métier comprendra alors que l'ouverture des commutateurs tertiaires 300 de la ou des rangées autres que la rangée 52 respective faisant l'objet de la programmation de cellule(s) mémoire 10 permet alors une plus grande souplesse de contrôle des lignes de source 36, puisqu'il est alors nécessaire de contrôler seulement le potentiel des deux lignes de source 36 situées de part et d'autre de la rangée 52 faisant l'objet de la programmation, c'est-à-dire d'appliquer le premier potentiel électrique V1 seulement à la ligne de source 36 du côté de la première borne principale 12 de chaque cellule mémoire 10 de ladite rangée 52, et respectivement d'appliquer le deuxième potentiel électrique V2 seulement à la ligne de source 36 connectée à la borne auxiliaire 16 de chaque cellule mémoire 10 de ladite rangée 52, les potentiels appliqués aux autres lignes de source 36 étant indifférents.

L'homme du métier comprendra également que la fermeture des commutateurs tertiaires 300 d'une rangée 52 respective, lors de la programmation de cellule(s) mémoire 10 de ladite rangée 52, offre en outre la possibilité de limiter le courant circulant à travers chaque memristor 20 de chaque cellule mémoire 10 faisant l'objet de ladite programmation, en appliquant alors par exemple le potentiel prédéfini de limitation VCOMPL à l'électrode de commande 28 de chaque commutateur tertiaire 300 correspondant via la ligne de programmation complémentaire 310 associée.

Aussi, bien qu'il soit possible selon le deuxième mode de réalisation, que le circuit électronique 30 comporte, en complément facultatif, en outre les commutateurs auxiliaires 80 connectés aux lignes de source 36, par analogie avec la variante de réalisation de la figure 3 dans le cas du premier mode de réalisation, l'homme du métier comprendra que ce complément facultatif présente un intérêt moindre selon le deuxième mode de réalisation, puisqu'il est alors déjà possible de limiter le courant circulant à travers chaque memristor 20 de chaque cellule mémoire 10 de par chaque commutateur tertiaire 300 respectif.

Les autres avantages de ce deuxième mode de réalisation sont analogues à ceux du premier mode de réalisation décrit précédemment, et ne sont pas décrits à nouveau.

Le fonctionnement de ce deuxième mode de réalisation est similaire à celui du premier mode de réalisation décrit précédemment, et va être à présent décrit en regard de la figure 12 représentant un organigramme du procédé de programmation d'au moins une cellule mémoire 10 d'une rangée 52 respective de cellules mémoire 10 selon le deuxième mode de réalisation ; puis en regard de la figure 13 représentant un organigramme du procédé de multiplication et accumulation d'un lot de cellule(s) mémoire 10 d'une colonne 54 respective de cellules mémoire 10 selon le deuxième mode de réalisation.

Sur la figure 12, le procédé de programmation comprend l'étape 100 d'ouverture des commutateurs primaires 22 des cellules mémoire 10 d'une rangée 52 respective, cette étape étant identique à l'étape d'ouverture 100 décrite précédemment pour le premier mode de réalisation en regard de la figure 8, et alors pas décrite à nouveau.

Le procédé de programmation comprend également l'étape 105 de fermeture d'éventuels autres commutateurs primaires 22 des cellules mémoire 10 de ladite rangée 52, cette étape étant identique à l'étape de fermeture 105 décrite précédemment pour le premier mode de réalisation à la figure 8, et n'étant donc pas décrite à nouveau.

Le procédé de programmation comprend également l'étape 110 de fermeture d'au moins un commutateur secondaire 24 d'au moins une cellule mémoire 10 de ladite rangée 52, cette étape étant identique à l'étape de fermeture 110 décrite précédemment pour le premier mode de réalisation à la figure 8, et n'étant donc pas décrite à nouveau.

Le procédé de programmation comprend en outre une étape 115 de fermeture des commutateurs tertiaires 300 des cellules mémoire 10 de ladite rangée 52, via l'application d'une commande de fermeture sur la ligne de programmation complémentaire 310 connectée à ladite rangée 52.

Lors de cette étape de fermeture 115, le premier contrôleur 42 commande alors la fermeture des commutateurs tertiaires 300 de ladite rangée 52.

Lors de cette étape de fermeture 115, en variante, le premier contrôleur 42 commande la fermeture des commutateurs tertiaires 300 connectés à une ligne de programmation complémentaire 310 respective associée à ladite rangée et l'ouverture des éventuels autres commutateurs tertiaires 300 des cellules mémoire 10 de ladite rangée 52, ces éventuels autres commutateurs tertiaires 300 étant alors connectés à d'autres lignes de programmation complémentaire 310 que celle à laquelle un signal de fermeture est appliqué. La ligne de programmation complémentaire 310 à laquelle est appliquée le signal de fermeture est celle associée à la sous-cellule 25 qui est elle-même associée à la ligne de valeur 32 à laquelle le signal d'ouverture est appliqué, la programmation d'une sous-cellule 25 respective requérant à la fois l'ouverture du commutateur primaire 22 et la fermeture du commutateur tertiaire 300 de ladite sous-cellule 25.

En complément facultatif, le procédé de programmation comprend en outre une étape 117 d'ouverture des autres commutateurs tertiaires 300, c'est-à-dire des commutateurs tertiaires 300 pour la ou les rangées 52 autre(s) que celle faisant l'objet de la programmation, via l'application d'une commande d'ouverture sur la ou les autres lignes de programmation complémentaire 310 du circuit électronique 30.

Lors de cette étape optionnelle d'ouverture 117, le premier contrôleur 42 commande alors l'ouverture des commutateurs tertiaires 300 de ladite ou desdites autres rangées 52.

À l'issue de ces étapes 100, 105, 110, 115, et optionnellement 117, le procédé de programmation comprend l'étape d'assignation 120 qui est similaire à celle décrite précédemment pour le premier mode de réalisation.

Selon le deuxième mode de réalisation, lors de l'étape d'assignation 120, le premier potentiel électrique V1 est de préférence appliqué à la seule ligne de source 36 reliée à l'au moins une première borne principale 12 et le deuxième potentiel électrique V2 étant appliqué à la seule ligne de source 36 connectée à l'au moins une borne auxiliaire 16 de ladite rangée 52. Selon ce deuxième mode de réalisation, le potentiel électrique appliqué aux éventuelles autres lignes de source 36 est alors indifférent, comme expliqué ci-dessus.

Sur la figure 13, le procédé de multiplication et accumulation comprend l'étape 200 d'ouverture des commutateurs secondaires 24 des cellules mémoire 10 de la colonne 54 faisant l'objet de cette multiplication et accumulation, cette étape étant identique à l'étape d'ouverture 200 décrite précédemment pour le premier mode de réalisation en regard de la figure 9, et alors pas décrite à nouveau.

Si le lot de cellule(s) mémoire 10 faisant l'objet de cette multiplication et accumulation n'inclut pas toutes les cellules mémoire 10 de la colonne 54 correspondante, le procédé de multiplication et accumulation selon le deuxième mode de réalisation comprend également l'étape 210 de fermeture de chaque commutateur primaire 22 de chaque cellule mémoire 10 distincte dudit lot au sein de ladite colonne 54, qui est identique à celle décrite précédemment pour le premier mode de réalisation à la figure 9, et n'est donc pas décrite à nouveau.

Le procédé de multiplication et accumulation selon le deuxième mode de réalisation comprend en outre, avant l'étape de pilotage 220, une étape 215 de fermeture de chaque commutateur tertiaire 300 dudit lot, via l'application d'une commande de fermeture sur chaque ligne de programmation complémentaire 310 connectée à chaque commutateur tertiaire 300 dudit lot.

Lors de cette étape de fermeture 215, le premier contrôleur 42 commande alors la fermeture de chaque commutateur tertiaire 300 dudit lot.

À l'issue de ces étapes 200, 210 et 215, le procédé de multiplication et accumulation comprend l'étape de pilotage 220, puis l'étape d'obtention 230, qui sont chacune identiques à celles décrites précédemment pour le premier mode de réalisation à la figure 9, et ne sont alors pas décrites à nouveau.

En complément, et quel que soit le mode de réalisation, l'homme du métier comprendra en outre que la cellule mémoire 10 selon invention, et le circuit électronique 30 associé, permettent également un procédé de lecture simple d'un lot cellule(s) mémoire 10 d'une colonne 54 respective, ce procédé de lecture simple étant une version simplifiée du procédé de multiplication et accumulation décrit précédemment en ayant un multiple égal à 1 pour chaque cellule mémoire 10 faisant l'objet de cette lecture simple.

Cette lecture simple est alors effectuée via l'ouverture de chaque commutateur primaire 22 dudit lot faisant l'objet de cette lecture ; et si ledit lot n'inclut pas toutes les cellules mémoire 10 de ladite colonne 54, via en outre la fermeture de chaque commutateur primaire 22 de chaque cellule mémoire 10 distincte dudit lot.

L'homme du métier observera alors que le fait d'avoir seulement l'ouverture de chaque commutateur primaire 22 dudit lot au cours du cycle d'inférence correspond bien à un multiple égal à 1, la durée cumulée d'ouverture dudit commutateur primaire 22 étant alors égale à la durée dudit cycle d'inférence, de sorte que le ratio $\rho$ précité est égal à 1.

L'homme du métier comprendra néanmoins que la lecture d'au moins une cellule mémoire 10 d'une rangée 52 respective est préférentiellement effectuée avec un procédé de lecture comprenant les étapes suivantes :

- ouverture de commutateurs primaires 22 des cellules mémoire 10 de ladite rangée 52, via l'application d'une commande d'ouverture sur une ligne de valeur 32 respective connectée à ladite rangée 52 ;
- fermeture d'éventuels autres commutateurs primaires 22 des cellules mémoire 10 de ladite rangée 52, via l'application d'une commande de fermeture sur la ou les éventuelles autres lignes de valeur 32 connectées à ladite rangée 52 ;
- fermeture de l'au moins un commutateur secondaire 24 de ladite au moins une cellule mémoire 10, via l'application d'une commande de fermeture sur l'au moins une ligne de programmation 34 connectée à ladite au moins une cellule mémoire 10 de ladite rangée 52 ;
- lecture d'une valeur d'au moins un memristor 20 de ladite au moins une cellule mémoire 10, avec une tension de lecture respective entre l'au moins une première borne principale 12 et l'au moins une borne auxiliaire 16 de ladite au moins une cellule mémoire 10, via l'application d'un troisième potentiel électrique V3 aux lignes de source 36 agencées du côté de l'au moins une première borne principale 12 et d'un quatrième potentiel électrique V4 aux autres lignes de source 36, agencées du côté l'au moins une borne auxiliaire 16, la tension de lecture étant égale à la différence entre les troisième et quatrième potentiels V3, V4, le ou chaque commutateur primaire 22 en parallèle dudit au moins un memristor 20 à lire étant ouvert.

La tension de lecture est alors typiquement d'environ 0,1 à 0,4 volt, et elle est par exemple obtenue en positionnant la valeur VH à cette valeur d'environ 0,1 à 0,4 volt, la valeur VL à une valeur sensiblement nulle, et le cas échéant la valeur VCOMPL à VDD.

On conçoit alors que la cellule mémoire 10 selon l'invention, et le circuit électronique 30 associé, permettent l'implémentation de tous types de réseaux de neurones, et notamment de réseaux de neurones autres que les seuls réseaux de neurones binaires, également appelés BNN.

## Revendications

**1.** Circuit électronique (30), comprenant :

- des lignes de valeur (32) ;
- des lignes de programmation (34) ;
- des lignes de source (36) ; et
- un ensemble (40) de cellules mémoire (10), chaque cellule mémoire (10) comprenant :

- une première borne principale (12), une deuxième borne principale (14) et une borne auxiliaire (16) ;
- M memristor(s) (20) connecté(s) entre les deux bornes principales (12, 14), M étant un nombre entier supérieur ou égal à 1 ;
- M commutateur(s) primaire(s) (22), chacun étant connecté en parallèle d'un memristor (20) respectif ; et
- un commutateur secondaire (24) connecté entre la deuxième borne principale (14) et la borne auxiliaire (16) ;

la cellule mémoire (10) étant configurée pour l'écriture d'une valeur respective dans au moins un memristor (20) via l'ouverture du ou de chaque commutateur primaire (22) en parallèle dudit au moins un memristor (20), la fermeture du ou de chaque éventuel autre commutateur primaire (22), la fermeture du commutateur secondaire (24) et l'application d'une tension de programmation correspondante entre la première borne principale (12) et la borne auxiliaire (16) ;
la cellule mémoire (10) étant configurée pour la lecture d'une valeur respective dans au moins un memristor (20)

via l'ouverture du ou de chaque commutateur primaire (22) en parallèle dudit au moins un memristor (20), la fermeture du ou de chaque éventuel autre commutateur primaire (22), l'ouverture du commutateur secondaire (24) et la mesure d'une grandeur électrique correspondante entre les deux bornes principales (12, 14), pour chaque cellule mémoire (10), une électrode de commande (28) d'un commutateur primaire (22) respectif étant connectée à une ligne de valeur (32) respective, une électrode de commande (28) du commutateur secondaire (24) étant connectée à une ligne de programmation (34) respective, et la borne auxiliaire (16) étant connectée à une ligne de source (36) respective ; et

les cellules mémoire (10) sont agencées en colonnes (54), les cellules mémoire (10) d'une même colonne (54) étant connectées en série les unes des autres, et le circuit électronique (30) comprend en outre des modules de mesure (60), chaque colonne (54) comportant une première extrémité (56) connectée à un potentiel de référence (VR) et une deuxième extrémité (58) connectée à un module de mesure (60) respectif, chaque module de mesure (60) comportant un commutateur de réinitialisation (64) et un condensateur (66) configuré, d'une part, pour être chargé par une tension cumulée des cellules mémoire (10) de la colonne (54) respective lors d'une phase de mesure, le commutateur de réinitialisation (64) étant alors ouvert ; et d'autre part, pour être déchargé par mise à une masse électrique (68) via la fermeture du commutateur de réinitialisation (64) lors d'une phase de réinitialisation.

2. Circuit électronique (30) selon la revendication 1, dans laquelle la cellule mémoire (10) est configurée en outre pour la multiplication d'une valeur d'au moins un memristor (20) respectif par un multiple ($X_{i,k}$), via une alternance d'ouverture(s) et de fermeture(s) du ou de chaque commutateur primaire (22) en parallèle dudit au moins un memristor (20) au cours d'un cycle d'inférence, la fermeture du ou de chaque éventuel autre commutateur primaire (22), l'ouverture du commutateur secondaire (24) et la mesure d'une grandeur électrique correspondante entre les deux bornes principales (12, 14), un ratio ($\rho$) entre une durée cumulée d'ouverture du ou de chaque commutateur primaire (22) en parallèle dudit au moins un memristor (20) au cours du cycle d'inférence et une durée dudit cycle étant représentatif du multiple ($X_{i,k}$).

3. Circuit électronique (30) selon la revendication 1 ou 2, dans laquelle la cellule mémoire (10) comprend en outre M commutateur(s) tertiaire(s) (300), chacun étant connecté à un memristor (20) respectif, le commutateur tertiaire (300) et le memristor (20) étant connectés en série, en parallèle du commutateur primaire (22) associé ;

la cellule mémoire (10) étant de préférence constituée des première et deuxième bornes principales (12, 14), de la borne auxiliaire (16), du memristor (20), et des commutateurs primaire(s), secondaire et tertiaire(s) (22, 24, 300).

4. Circuit électronique (30) selon l'une quelconque des revendications précédentes, dans laquelle M est égal à 1, et la cellule mémoire (10) est alors configurée pour l'écriture d'une valeur respective via l'ouverture du commutateur primaire (22), la fermeture du commutateur secondaire (24) et l'application d'une tension de programmation correspondante entre la première borne principale (12) et la borne auxiliaire (16) ; la cellule mémoire (10) étant configurée pour la lecture d'une valeur respective via l'ouverture du commutateur primaire (22), l'ouverture du commutateur secondaire (24) et la mesure d'une grandeur électrique correspondante entre les deux bornes principales (12, 14).

5. Circuit électronique (30) selon l'une quelconque des revendications précédentes, dans laquelle M est strictement supérieur à 1, les M memristors (20) sont connectés en série entre les deux bornes principales (12, 14), et la cellule mémoire (10) est configurée pour l'écriture d'une valeur respective dans un memristor (20) via l'ouverture du commutateur primaire (22) en parallèle dudit memristor (20), la fermeture du ou de chaque autre commutateur primaire (22), la fermeture du commutateur secondaire (24) et l'application d'une tension de programmation correspondante entre la première borne principale (12) et la borne auxiliaire (16) ; la cellule mémoire (10) étant configurée pour la lecture d'une valeur respective dans un memristor (20) via l'ouverture du commutateur primaire (22) en parallèle dudit memristor (20), la fermeture du ou de chaque autre commutateur primaire (22), l'ouverture du commutateur secondaire (24) et la mesure d'une grandeur électrique correspondante entre les deux bornes principales (12, 14).

6. Circuit électronique (30) selon l'une quelconque des revendications précédentes, dans lequel chaque cellule mémoire (10) est selon la revendication 3, le circuit électronique (30) comprend en outre des lignes de programmation complémentaire (310), et pour chaque cellule mémoire (10), une électrode de commande (28) d'un commutateur tertiaire (300) respectif est connectée à une ligne de programmation complémentaire (310) respective.

7. Circuit électronique (30) selon l'une quelconque des revendications précédentes, dans lequel le circuit électronique (30) comprend en outre des multiplexeurs (72), chaque ligne de source (36) étant connectée à un multiplexeur (72) respectif, chaque multiplexeur (72) étant configuré pour sélectionner, en fonction d'un signal de sélection et parmi plusieurs valeurs prédéfinies (VH, VL), une valeur de potentiel électrique à appliquer à la ligne de source (36) associée.

8. Circuit électronique (30) selon l'une quelconque des revendications précédentes, dans lequel le circuit électronique (30) comprend en outre des commutateurs auxiliaires (80), chaque ligne de source (36) étant connectée à un commutateur auxiliaire (80) respectif, chaque commutateur auxiliaire (80) étant configuré pour, en cas de réception d'une commande de limitation, limiter un courant électrique circulant dans la ligne de source (36) associée ;

chaque commutateur auxiliaire (80) étant de préférence un transistor (26), et la commande de limitation étant un potentiel prédéfini de limitation appliqué à une électrode de commande (28) dudit commutateur auxiliaire (80) ; le circuit électronique (30) comprenant de préférence encore des multiplexeurs auxiliaires (82), l'électrode de commande (28) de chaque commutateur auxiliaire (80) étant connectée à un multiplexeur auxiliaire (82) respectif, chaque multiplexeur auxiliaire (82) étant configuré pour sélectionner, en fonction d'un signal de limitation et parmi plusieurs valeurs prédéfinies (VCOMPL, VDD), une valeur de potentiel électrique à appliquer à l'électrode de commande (28) associée.

9. Circuit électronique (30) selon la revendication 6, dans lequel les cellules mémoire (10) sont agencées en rangées (52), et les cellules mémoire (10) d'une même rangée (52) sont connectées en outre à M même(s) ligne(s) de programmation complémentaire (310).

10. Circuit électronique (30) selon l'une quelconque des revendications précédentes, dans lequel chaque module de mesure (60) est configuré pour mesurer une tension cumulée des cellules mémoire (10) de la colonne (54) à laquelle il est connecté ;

le circuit électronique (30) comprenant de préférence en outre une ligne de référence (38) à laquelle est appliquée le potentiel de référence (VR), les premières extrémités (56) des colonnes (54) étant alors connectées à la ligne de référence (38) ; chaque module de mesure (60) comportant de préférence encore un comparateur (62) configuré pour détecter l'atteinte, par la tension cumulée des cellules mémoire (10) de la colonne (54) respective, d'une tension prédéfinie de seuil respective.

11. Procédé de programmation d'au moins une cellule mémoire (10) d'une rangée (52) respective de cellules mémoire (10) d'un circuit électronique (30) selon la revendication 9, le procédé comprenant les étapes suivantes :

- ouverture (100) de commutateurs primaires (22) des cellules mémoire (10) de ladite rangée (52), via l'application d'une commande d'ouverture sur une ligne de valeur (32) respective connectée à ladite rangée (52) ;
- fermeture (105) d'éventuels autres commutateurs primaires (22) des cellules mémoire (10) de ladite rangée (52), via l'application d'une commande de fermeture sur la ou les éventuelles autres lignes de valeur (32) connectées à ladite rangée (52) ;
- fermeture (110) de l'au moins un commutateur secondaire (24) de ladite au moins une cellule mémoire (10), via l'application d'une commande de fermeture sur l'au moins une ligne de programmation (34) connectée à ladite au moins une cellule mémoire (10) de ladite rangée (52) ;
- fermeture (115) des commutateurs tertiaires (300) des cellules mémoire (10) de ladite rangée (52), via l'application d'une commande de fermeture sur la ou les lignes de programmation complémentaire (310) connectées à ladite rangée (52) ;
- assignation (120) d'une valeur à au moins un memristor (20) de ladite au moins une cellule mémoire (10), avec une tension de programmation correspondant à la valeur entre l'au moins une première borne principale (12) et l'au moins une borne auxiliaire (16) de ladite au moins une cellule mémoire (10), via l'application d'un premier potentiel électrique (V1) au(x) ligne(s) de source (36) agencée(s) du côté de l'au moins une première borne principale (12) et d'un deuxième potentiel électrique (V2) au(x) autre(s) ligne(s) de source (36), agencée(s) du côté l'au moins une borne auxiliaire (16), la tension de programmation correspondant à la valeur assignée étant égale à la différence entre les premier et deuxième potentiels (V1, V2), le ou chaque commutateur primaire (22) en parallèle dudit au moins un memristor (20) étant ouvert ;
lors de l'étape d'assignation (120), le premier potentiel électrique (V1) étant de préférence appliqué à la seule ligne de source (36) reliée à l'au moins une première borne principale (12) et le deuxième potentiel électrique (V2) étant appliqué à la seule ligne de source (36) connectée à l'au moins une borne auxiliaire (16) de ladite rangée (52) ;

le procédé comprenant de préférence encore, avant l'étape d'assignation (120), en outre une étape d'ouverture (117) des autres commutateurs tertiaires (300), via l'application d'une commande d'ouverture sur la ou les autres lignes de programmation complémentaire (310) du circuit électronique (30).

12. Procédé de multiplication et accumulation d'un lot de cellule(s) mémoire (10) d'une colonne (54) respective de cellules mémoire (10) d'un circuit électronique (30) selon la revendication 10, le procédé comprenant les étapes suivantes :

- ouverture (200) des commutateurs secondaires (24) des cellules mémoire (10) de ladite colonne (54), via l'application d'une commande d'ouverture sur la ligne de programmation (34) connectée à ladite colonne (54) ;
- si ledit lot n'inclut pas toutes les cellules mémoire (10) de ladite colonne (54), fermeture (210) de chaque commutateur primaire (22) de chaque cellule mémoire (10) distincte dudit lot au sein de ladite colonne (54), via l'application d'une commande de fermeture sur chaque ligne de valeur (32) connectée à chaque cellule mémoire (10) distincte dudit lot ;
- pilotage (220) de chaque commutateur primaire (22) dudit lot de cellule(s) mémoire avec une alternance d'ouverture(s) et de fermeture(s) au cours d'un cycle d'inférence, via l'application de commandes alternées d'ouverture(s) et de fermeture(s) sur chaque ligne de valeur (32) connectée à chaque commutateur primaire (22) dudit lot, pour multiplier la valeur de chaque memristor (20) dudit lot par un multiple respectif ($X_{i,k}$) ; un ratio ($\rho$) entre une durée cumulée d'ouverture du commutateur primaire (22) respectif au cours du cycle d'inférence et une durée dudit cycle étant représentatif du multiple respectif ($X_{i,k}$) ;
- obtention (230) d'une somme pondérée de valeur(s) de memristor(s) (20) dudit lot, chaque valeur de memristor (20) étant multipliée par le multiple respectif ($X_{i,k}$), via une mesure de la tension cumulée des cellules mémoire (10) de ladite colonne (54).

13. Procédé de multiplication et accumulation selon la revendication 12, le circuit électronique (30) étant selon les revendications 9 et 10, dans lequel le procédé comprend en outre, avant l'étape de pilotage (220), une étape de fermeture (215) de chaque commutateur tertiaire (300) dudit lot, via l'application d'une commande de fermeture sur chaque ligne de programmation complémentaire (310) connectée à chaque commutateur tertiaire (300) dudit lot.

**Patentansprüche**

1. Elektronische Schaltung (30), umfassend:

- Werteleitungen (32);
- Programmierleitungen (34);
- Quellenleitungen (36); und
- einen Satz (40) von Speicherzellen (10), jede Speicherzelle (10) umfassend:
- einen ersten Hauptanschluss (12), einen zweiten Hauptanschluss (14) und einen Hilfsanschluss (16);
- M Memristor(en) (20), der/die zwischen den zwei Hauptanschlüssen (12, 14) verbunden ist/sind, wobei M eine ganze Zahl größer als oder gleich wie 1 ist;
- M Primärschalter (22), die jeweils parallel zu einem jeweiligen Memristor (20) verbunden sind; und
- einen Sekundärschalter (24), der zwischen dem zweiten Hauptanschluss (14) und dem Hilfsanschluss (16) verbunden ist;
wobei die Speicherzelle (10) zum Schreiben eines jeweiligen Werts in mindestens einen Memristor (20) über das Öffnen des oder jedes Primärschalters (22) parallel zu dem mindestens einen Memristor (20), das Schließen des oder jedes möglichen anderen Primärschalters (22), das Schließen des Sekundärschalters (24) und das Anlegen einer entsprechenden Programmierspannung zwischen dem ersten Hauptanschluss (12) und dem Hilfsanschluss (16) konfiguriert ist;
wobei die Speicherzelle (10) zum Lesen eines entsprechenden Werts in mindestens einem Memristor (20) über das Öffnen des oder jedes Primärschalters (22) parallel zu dem mindestens einen Memristor (20), das Schließen des oder jedes möglichen anderen Primärschalters (22), das Öffnen des Sekundärschalters (24) und das Messen einer entsprechenden elektrischen Größe zwischen den zwei Hauptanschlüssen (12, 14) konfiguriert ist, wobei für jede Speicherzelle (10) eine Steuerelektrode (28) eines jeweiligen Primärschalters (22) mit einer jeweiligen Werteleitung (32) verbunden ist, eine Steuerelektrode (28) des Sekundärschalters (24) mit einer jeweiligen Programmierleitung (34) verbunden ist und der Hilfsanschluss (16) mit einer jeweiligen Quellenleitung (36) verbunden ist; und
die Speicherzellen (10) in Spalten (54) angeordnet sind, wobei die Speicherzellen (10) einer gleichen Spalte (54) in Reihe miteinander verbunden sind, und die elektronische Schaltung (30) ferner Messmodule (60) umfasst, wobei jede Spalte (54) ein erstes Ende (56), das mit einem Bezugspotenzial (VR) verbunden ist, und ein zweites Ende (58), das mit einem jeweiligen Messmodul (60) verbunden ist, aufweist, wobei jedes Messmodul (60) einen Rücksetzschalter (64) und einen Kondensator (66) umfasst, der konfiguriert ist, um einerseits durch eine kumulierte Spannung der Speicherzellen (10) der jeweiligen Spalte (54) während einer Messphase geladen zu werden, wobei der Rücksetzschalter (64) dann offen ist; und andererseits, um durch Anlegen an eine elektrische Masse (68) über das Schließen des Rücksetzschalters (64) während einer Rücksetzphase entladen zu werden.

2. Elektronische Schaltung (30) nach Anspruch 1, wobei die Speicherzelle (10) zusätzlich für die Multiplikation eines Werts mindestens eines jeweiligen Memristors (20) mit einem Vielfachen ($X_{i,k}$) konfiguriert ist, über ein abwechselndes Öffnen und Schließen des oder jedes Primärschalters (22) parallel zu dem mindestens einen Memristor (20) während eines Inferenzzyklus, das Schließen des oder jedes möglichen anderen Primärschalters (22), das Öffnen des Sekundärschalters (24) und das Messen einer entsprechenden elektrischen Größe zwischen den beiden Hauptanschlüssen (12, 14) konfiguriert ist, wobei ein Verhältnis (*p*) zwischen einer kumulierten Dauer des Öffnens des oder jedes Primärschalters (22) parallel zu dem mindestens einen Memristor (20) im Verlauf des Inferenzzyklus und einer Dauer des Zyklus repräsentativ für das Vielfache ($X_{i,k}$) ist.

3. Elektronische Schaltung (30) nach Anspruch 1 oder 2, wobei die Speicherzelle (10) ferner M Tertiärschalter (300) umfasst, die jeweils mit einem entsprechenden Memristor (20) verbunden sind, wobei der Tertiärschalter (300) und der Memristor (20) in Reihe parallel zu dem assoziierten Primärschalter (22) verbunden sind;
wobei die Speicherzelle (10) vorzugsweise aus dem ersten und zweiten Hauptanschluss (12, 14), dem Hilfsanschluss (16), dem Memristor (20) und dem/den Primär-, Sekundär- und Tertiärschalter(n) (22, 24, 300) besteht.

4. Elektronische Schaltung (30) nach einem der vorherigen Ansprüche, wobei M gleich 1 ist und die Speicherzelle (10) dann zum Schreiben eines jeweiligen Werts über das Öffnen des Primärschalters (22), das Schließen des Sekundärschalters (24) und das Anlegen einer entsprechenden Programmierspannung zwischen dem ersten Hauptanschluss (12) und dem Hilfsanschluss (16) konfiguriert ist; wobei die Speicherzelle (10) zum Lesen eines jeweiligen Werts über das Öffnen des Primärschalters (22), das Öffnen des Sekundärschalters (24) und das Messen einer entsprechenden elektrischen Größe zwischen den zwei Hauptanschlüssen (12, 14) konfiguriert ist.

5. Elektronische Schaltung (30) nach einem der vorherigen Ansprüche, wobei M strikt größer ist als 1, die M Memristoren (20) zwischen den zwei Hauptanschlüssen (12, 14) in Reihe verbunden sind, und wobei die Speicherzelle (10) zum Schreiben eines jeweiligen Werts in einen Memristor (20) über das Öffnen des Primärschalters (22) parallel zu dem einen Memristor (20), das Schließen des oder jedes anderen Primärschalters (22), das Schließen des Sekundärschalters (24) und das Anlegen einer entsprechenden Programmierspannung zwischen dem ersten Hauptanschluss (12) und dem Hilfsanschluss (16) konfiguriert ist; wobei die Speicherzelle (10) zum Lesen eines entsprechenden Werts in einem Memristor (20) über das Öffnen des Primärschalters (22) parallel zu dem einen Memristor (20), das Schließen des oder jedes anderen Primärschalters (22), das Öffnen des Sekundärschalters (24) und das Messen einer entsprechenden elektrischen Größe zwischen den zwei Hauptanschlüssen (12, 14) konfiguriert ist.

6. Elektronische Schaltung (30) nach einem der vorherigen Ansprüche, wobei jede Speicherzelle (10) nach Anspruch 3 ist, die elektronische Schaltung (30) ferner komplementäre Programmierleitungen (310) umfasst, und für jede Speicherzelle (10) eine Steuerelektrode (28) eines jeweiligen Tertiärschalters (300) mit einer jeweiligen komplementären Programmierleitung (310) verbunden ist.

7. Elektronische Schaltung (30) nach einem der vorherigen Ansprüche, wobei die elektronische Schaltung (30) ferner Multiplexer (72) umfasst, wobei jede Quellenleitung (36) mit einem jeweiligen Multiplexer (72) verbunden ist, jeder Multiplexer (72) konfiguriert ist, um abhängig von einem Auswahlsignal und aus mehreren vordefinierten Werten (VH, VL) einen Wert des elektrischen Potenzials auszuwählen, der an die assoziierte Quellenleitung (36) angelegt werden soll.

8. Elektronische Schaltung (30) nach einem der vorherigen Ansprüche, wobei die elektronische Schaltung (30) ferner Hilfsschalter (80) umfasst, wobei jede Quellenleitung (36) mit einem jeweiligen Hilfsschalter (80) verbunden ist, wobei jeder Hilfsschalter (80) konfiguriert ist, um bei Empfang eines Begrenzungsbefehls einen in der assoziierten Quellenleitung (36) fließenden elektrischen Strom zu begrenzen;

jeder Hilfsschalter (80) vorzugsweise ein Transistor (26) ist, und wobei der Begrenzungsbefehl ein vordefiniertes Begrenzungspotenzial ist, das an eine Steuerelektrode (28) des Hilfsschalters (80) angelegt wird;

die elektronische Schaltung (30) vorzugsweise umfassend noch Hilfsmultiplexer (82), die Steuerelektrode (28) von jedem Hilfsschalter (80) mit einem jeweiligen Hilfsmultiplexer (82) verbunden ist, jeder Hilfsmultiplexer (82) konfiguriert ist, um abhängig von einem Begrenzungssignal und aus mehreren vordefinierten Werten (VCOMPL, VDD) einen Wert des elektrischen Potenzials auszuwählen, der an die assoziierte Steuerelektrode (28) angelegt werden soll.

9. Elektronische Schaltung (30) nach Anspruch 6, wobei die Speicherzellen (10) in Reihen (52) angeordnet sind, und die Speicherzellen (10) einer gleichen Reihe (52) zusätzlich mit M gleichen komplementären Programmierleitung(en) (310) verbunden sind.

10. Elektronische Schaltung (30) nach einem der vorherigen Ansprüche, wobei jedes Messmodul (60) konfiguriert ist, um eine kumulierte Spannung der Speicherzellen (10) der Spalte (54) zu messen, mit der es verbunden ist;

wobei die elektronische Schaltung (30) vorzugsweise ferner eine Referenzleitung (38) umfasst, an die das Referenzpotential (VR) angelegt wird, wobei die ersten Enden (56) der Spalten (54) dann mit der Referenzleitung (38) verbunden sind;
wobei jedes Messmodul (60) vorzugsweise ferner einen Komparator (62) umfasst, der konfiguriert ist, um zu erfassen, wenn die kumulierte Spannung der Speicherzellen (10) der jeweiligen Spalte (54) eine jeweilige vordefinierte Schwellenwertspannung erreicht.

11. Verfahren zum Programmieren mindestens einer Speicherzelle (10) einer jeweiligen Reihe (52) von Speicherzellen (10) einer elektronischen Schaltung (30) nach Anspruch 9, das Verfahren umfassend die folgenden Schritte:

- Öffnen (100) von Primärschaltern (22) der Speicherzellen (10) in der Reihe (52) über die Anwendung eines Öffnungsbefehls auf eine jeweilige Wertleitung (32), die mit der Reihe (52) verbunden ist;
- Schließen (105) von möglichen anderen Primärschaltern (22) der Speicherzellen (10) der Reihe (52) über die Anwendung eines Schließbefehls auf die mögliche(n) andere(n) Werteleitung(en) (32), die mit der Reihe (52) verbunden ist/sind;
- Schließen (110) des mindestens einen Sekundärschalters (24) der mindestens einen Speicherzelle (10) durch Anwenden eines Schließbefehls auf die mindestens eine Programmierleitung (34), die mit der mindestens einen Speicherzelle (10) in der Reihe (52) verbunden ist;
- Schließen (115) der Tertiärschalter (300) der Speicherzellen (10) in der Reihe (52) durch Anwenden eines Schließbefehls auf die komplementäre(n) Programmierleitung(en) (310), die mit der Reihe (52) verbunden ist/sind;
- Zuweisen (120) eines Werts an mindestens einen Memristor (20) der mindestens einen Speicherzelle (10), wobei eine Programmierspannung dem Wert zwischen dem mindestens einen ersten Hauptanschluss (12) und dem mindestens einen Hilfsanschluss (16) der mindestens einen Speicherzelle (10) entspricht, über das Anlegen eines ersten elektrischen Potentials (V1) an die Quellenleitung(en) (36), die auf der Seite des mindestens einen ersten Hauptanschlusses (12) angeordnet ist/sind, und eines zweiten elektrischen Potentials (V2) an die andere(n) Quellenleitung(en) (36), die auf der Seite des mindestens einen Hilfsanschlusses (16) angeordnet ist/sind, wobei die dem zugewiesenen Wert entsprechende Programmierspannung gleich wie die Differenz zwischen dem ersten und dem zweiten Potenzial (V1, V2) ist, wobei der oder jeder Primärschalter (22) parallel zu dem mindestens einen Memristor (20) offen ist;
in dem Zuweisungsschritt (120) das erste elektrische Potential (V1) vorzugsweise an die einzige Quellenleitung (36) angelegt wird, die mit dem mindestens einen ersten Hauptanschluss (12) verbunden ist, und das zweite elektrische Potential (V2) an die einzige Quellenleitung (36) angelegt wird, die mit dem mindestens einen Hilfsanschluss (16) der Reihe (52) verbunden ist;
das Verfahren umfassend vorzugsweise vor dem Zuweisungsschritt (120) ferner zusätzlich einen Schritt eines Öffnens (117) der anderen Tertiärschalter (300) über die Anwendung eines Öffnungsbefehls auf die andere(n) komplementäre(n) Programmierleitung(en) (310) der elektronischen Schaltung (30).

12. Verfahren zum Multiplizieren und Akkumulieren eines Stapels von Speicherzelle(n) (10) einer jeweiligen Spalte (54) von Speicherzellen (10) einer elektronischen Schaltung (30) nach Anspruch 10, das Verfahren umfassend die folgenden Schritte:

- Öffnen (200) der Sekundärschalter (24) der Speicherzellen (10) in der Spalte (54) durch Anwenden eines Öffnungsbefehls auf die mit der Spalte (54) verbundene Programmierleitung (34);
- wenn der Stapel nicht alle Speicherzellen (10) in der Spalte (54) beinhaltet, Schließen (210) jedes Primärschalters (22) jeder separaten Speicherzelle (10) des Stapels innerhalb der Spalte (54) durch Anwenden eines Schließbefehls auf jede Werteleitung (32), die mit jeder separaten Speicherzelle (10) des Stapels verbunden ist;

- Ansteuern (220) jedes Primärschalters (22) des Speicherzellenstapels mit abwechselndem Öffnen und Schließen während eines Inferenzzyklus durch Anlegen abwechselnder Öffnungs- und Schließbefehle an jede mit jedem Primärschalter (22) des Stapels verbundene Werteleitung (32), um den Wert jedes Memristors (20) des Stapels mit einem jeweiligen Vielfachen ($X_{i,k}$) zu multiplizieren; wobei ein Verhältnis ($\rho$) zwischen einer kumulativen Öffnungsdauer des jeweiligen Primärschalters (22) während des Inferenzzyklus und einer Dauer des Zyklus repräsentativ für das jeweilige Vielfache ($X_{i,k}$) ist;

- Erlangen (230) einer gewichteten Summe von Memristorwert(en) (20) der Losgröße, wobei jeder Wert des Memristors (20) mit dem jeweiligen Vielfachen ($X_{i,k}$) multipliziert wird, über eine Messung der kumulierten Spannung der Speicherzellen (10) der Spalte (54).

**13.** Verfahren zum Multiplizieren und Akkumulieren nach Anspruch 12, wobei die elektronische Schaltung (30) nach den Ansprüchen 9 und 10 ist, wobei das Verfahren vor dem Schritt eines Ansteuerns (220) ferner einen Schritt zum Schließen (215) jedes Tertiärschalters (300) der Losgröße umfasst, über die Anwendung eines Schließbefehls auf jede komplementäre Programmierleitung (310), die mit jedem Tertiärschalter (300) der Losgröße verbunden ist.

**Claims**

**1.** An electronic circuit (30), comprising:

- value lines (32);
- programming lines (34);
- source lines (36); and
- a set (40) of memory cells (10), each memory cell (10) comprising:

+ a first main terminal (12), a second main terminal (14) and an auxiliary terminal (16);
+ M memristor(s) (20) connected between the two main terminals (12, 14), M being an integer greater than or equal to 1;
+ M primary switch(es) (22), each being connected in parallel to a respective memristor (20); and
+ a secondary switch (24) connected between the second main terminal (14) and the auxiliary terminal (16); the memory cell (10) being configured to write a respective value to the at least one memristor (20) via the opening of the or each primary switch (22) in parallel with said at least one memristor (20), closing the or each other possible primary switch (22), closing the secondary switch (24) and the application of a corresponding programming voltage between the first main terminal (12) and the auxiliary terminal (16); the memory cell (10) being configured to read a respective value in at least one memristor (20) via the opening of the or each primary switch (22) in parallel with said at least one memristor (20), closing the or each other possible primary switch (22), opening the secondary switch (24) and measuring a corresponding electric quantity between the two main terminals (12, 14), for each memory cell (10), a control electrode (28) of a respective primary switch (22) being connected to a respective value line (32), a control electrode (28) of the secondary switch (24) being connected to a respective programming line (34), and the auxiliary terminal (16) being connected to a respective source line (36); and the memory cells (10) are arranged in columns (54), the memory cells (10) of a same column (54) being connected in series with each other, and the electronic circuit (30) further comprises measurement modules (60), each column (54) including a first end (56) connected to a reference potential (VR) and a second end (58) connected to a respective measurement module (60), each measurement module (60) including a reset switch (64) and a capacitor (66) configured, on the one hand, to be charged by a cumulative voltage of the memory cells (10) of the respective column (54) during a measurement phase, the reset switch (64) then being open; and on the other hand, to be discharged by connecting to an electrical ground (68) via the closing of the reset switch (64) during a reset phase.

**2.** The electronic circuit (30) according to claim 1, wherein the memory cell (10) is further configured for multiplying a value of at least one respective memristor (20) by a multiple ($X_{i,k}$); via alternating opening and closing of the or each primary switch (22) in parallel with said at least one memristor (20) during an inference cycle, the closing of the or each other possible primary switch (22), the opening of the secondary switch (24) and the measurement of a corresponding electrical quantity between the two main terminals (12, 14), a ratio ($\rho$) between a cumulative duration of opening of the or each primary switch (22) in parallel with said at least one memristor (20) during the inference cycle and a duration of said inference cycle being representative of the multiple ($X_{i,k}$).

3. The electronic circuit (30) according to claim 1 or 2, wherein the memory cell (10) further comprises M tertiary switch(es) (300), each being connected to a respective memristor (20), the tertiary switch (300) and the memristor (20) being connected in series, in parallel with the associated primary switch (22);
the memory cell (10) preferably being constituted of the first and second main terminals (12, 14), the auxiliary terminal (16), the memristor (20), and the primary, secondary and tertiary switches (22, 24, 300).

4. The electronic circuit (30) according to any one of the preceding claims, wherein M is equal to 1, and the memory cell (10) is then configured to write a respective value via the opening of the primary switch (22), closing the secondary switch (24), and applying a corresponding programming voltage between the first main terminal (12) and the auxiliary terminal (16); the memory cell (10) being configured to read a respective value via the opening of the primary switch (22), opening the secondary switch (24) and measuring a corresponding electrical quantity between the two main terminals (12, 14).

5. The electronic circuit (30) according to any one of the preceding claims, wherein M is strictly greater than 1, the M memristors (20) are connected in series between the two main terminals (12, 14), and the memory cell (10) is configured for writing a respective value to a memristor (20) via the opening of the primary switch (22) in parallel with said memristor (20), closing the or each other primary switch (22), closing the secondary switch (24) and applying a corresponding programming voltage between the first main terminal (12) and the auxiliary terminal (16); the memory cell (10) being configured to read a respective value in a memristor (20) by opening the primary switch (22) in parallel with said memristor (20), closing the or each other primary switch (22), opening the secondary switch (24) and measuring a corresponding electrical quantity between the two main terminals (12, 14).

6. The electronic circuit (30) according to any one of the preceding claims, wherein each memory cell (10) is according to claim 3, the electronic circuit (30) further comprises complementary programming lines (310), and for each memory cell (10) a control electrode (28) of a respective tertiary switch (300) is connected to a respective complementary programming line (310).

7. The electronic circuit (30) according to any one of the preceding claims, wherein the electronic circuit (30) further comprises multiplexers (72), each source line (36) being connected to a respective multiplexer (72), each multiplexer (72) being configured to select, as a function of a selection signal and from among a plurality of predefined values (VH, VL), an electric potential value to be applied to the associated source line (36).

8. The electronic circuit (30) according to any one of the preceding claims, wherein the electronic circuit (30) further comprises auxiliary switches (80), each source line (36) being connected to a respective auxiliary switch (80), each auxiliary switch (80) being configured to, in case of receipt of a limitation command, limit an electric current flowing in the associated source line (36);

each auxiliary switch (80) preferably being a transistor (26), and the limitation command being a predefined limiting potential applied to a control electrode (28) of said auxiliary switch (80);
the electronic circuit (30) preferably further comprising auxiliary multiplexers (82), the control electrode (28) of each auxiliary switch (80) being connected to a respective auxiliary multiplexer (82), each auxiliary multiplexer (82) being configured to select, as a function of a limit signal and from among a plurality of predefined values (VCOMPL, VDD), an electric potential value to be applied to the associated control electrode (28).

9. The electronic circuit (30) according to claim 6, wherein the memory cells (10) are arranged in rows (52), and the memory cells (10) in the same row (52) are further connected to M same complementary programming line(s) (310).

10. The electronic circuit (30) according to any one of the preceding claims, wherein each measurement module (60) is configured to measure a cumulative voltage of the memory cells (10) in the column (54) to which it is connected;

the electronic circuit (30) preferably further comprising a reference line (38) to which the reference potential (VR) is applied, the first ends (56) of the columns (54) then being connected to the reference line (38);
each measurement module (60) preferably also includes a comparator (62) configured to detect when the cumulative voltage of the memory cells (10) of the respective column (54) attains a respective predefined threshold voltage.

11. A method of programming at least one memory cell (10) of a respective row (52) of memory cells (10) of an electronic circuit (30) according to claim 9, the method comprising the following steps:

- opening (100) of the primary switches (22) of the memory cells (10) of said row (52), via the application of an open command on a respective value line (32) connected to said row (52);
- closing (105) any other possible primary switches (22) of the memory cells (10) of said row (52), by the application of a close command on the other possible value line(s) (32) connected to said row (52);
- closing (110) of the at least one secondary switch (24) of said at least one memory cell (10), via the application of a close command on the at least one programming line (34) connected to said at least one memory cell (10) of said row (52);
- closing (115) the tertiary switches (300) of the memory cells (10) of said row (52), via the application of a close command on the one or more complementary programming lines (310) connected to said row (52);
- assigning (120) a value to at least one memristor (20) of said at least one memory cell (10), with a programming voltage corresponding to the value between the at least one main terminal (12) and the at least one auxiliary terminal (16) of said at least one memory cell (10) by applying a first electric potential (V1) to the source line(s) (36) arranged on the side of the at least one first main terminal (12) and a second electric potential (V2) to the other source line(s) (36), arranged on the side of the at least one auxiliary terminal (16), the programming voltage corresponding to the assigned value being equal to the difference between the first and second potentials (V1, V2), the or each primary switch (22) in parallel with the at least one memristor (20) being open;
during the assignment step (120), the first electric potential (V1) preferably being applied to the only source line (36) connected to the at least one first main terminal (12) and the second electric potential (V2) being applied to the only source line (36) connected to the at least one auxiliary terminal (16) of said row (52);
the method preferably still comprising, before the assignment step (120), furthermore a step of opening (117) the other tertiary switches (300), via the application of an open command to the or the other complementary programming line(s) (310) of the electronic circuit (30).

12. A method for multiplying and accumulating a set of memory cell(s) (10) of a respective column (54) of memory cells (10) of an electronic circuit (30) according to claim 10, the method comprising the following steps:

- opening (200) the secondary switches (24) of the memory cells (10) of said column (54), via the application of an open command on the programming line (34) connected to said column (54);
- if said set does not include all memory cells (10) in said column (54), closing (210) each primary switch (22) of each distinct memory cell (10) in said set within said column (54), by the application of a close command to each value line (32) connected to each distinct memory cell (10) in said set;
- controlling (220) each primary switch (22) of said set of memory cell(s) with alternating opening and closing during an inference cycle, via the application of alternating open and close commands on each value line (32) connected to each primary switch (22) of said set, to multiply the value of each memristor (20) of said set by a respective multiple ($X_{i,k}$); a ratio ($\rho$) between a cumulative duration of opening of the respective primary switch (22) during the inference cycle and a duration of said cycle being representative of the respective multiple ($X_{i,k}$);
- obtaining (230) a weighted sum of memristor value(s) (20) of said set, each memristor value (20) being multiplied by the respective multiple ($X_{i,k}$), via a measurement of the cumulative voltage of the memory cells (10) of said column (54).

13. A method for multiplying and accumulating according to claim 12, the electronic circuit (30) being according to claims 9 and 10, wherein the method further comprises, before the control step (220), a step of closing (215) each tertiary switch (300) of said set, via the application of a close command on each complementary programming line (310) connected to each tertiary switch (300) of said set.

FIG.1

**FIG.2**

FIG.3

## FIG.4

## FIG.5

**FIG.6**

FIG.7

Ouverture des commutateurs primaires,
associés à une ligne de valeur respective,
des cellules mémoire d'une rangée ⌐100

Fermeture d'éventuels autres commutateurs
primaires des cellules mémoire de la rangée ⌐105

Fermeture d'au moins un commutateur secondaire
d'au moins une cellule mémoire de la rangée ⌐110

Assignation d'une valeur à au moins un memristor
de l'au moins une cellule mémoire ⌐120

FIG.8

| Ouverture des commutateurs secondaires des cellules mémoire d'une colonne | 200 |

| Fermeture de chaque commutateur primaire de chaque cellule mémoire distincte d'un lot de cellule(s) mémoire de la colonne | 210 |

| Pilotage de chaque commutateur primaire dudit lot de cellule(s) mémoire, avec une alternance d'ouverture(s) et de fermeture(s) au cours d'un cycle de lecture. | 220 |

| Obtention d'une somme pondérée de valeur(s) de memristor(s) dudit lot | 230 |

## FIG.9

FIG.10

FIG.11

Ouverture des commutateurs primaires,
associés à une ligne de valeur respective,
des cellules mémoire d'une rangée ⟋100

Fermeture d'éventuels autres commutateurs
primaires des cellules mémoire de la rangée ⟋105

Fermeture d'au moins un commutateur secondaire,
d'au moins une cellule mémoire de la rangée ⟋110

Fermeture des commutateurs tertiaires,
des cellules mémoire de la rangée ⟋115

Ouverture des commutateurs tertiaires des
cellules mémoire des autres rangées ⟋117

Assignation d'une valeur à au moins un memristor
de l'au moins une cellule mémoire ⟋120

## FIG.12

```
┌─────────────────────────────────────────────────────┐
│          Ouverture des commutateurs secondaires       │─── 200
│             des cellules mémoire d'une colonne        │
└─────────────────────────────────────────────────────┘
                          │
                          ▼
┌─────────────────────────────────────────────────────┐
│         Fermeture de chaque commutateur primaire      │─── 210
│           de chaque cellule mémoire distincte         │
│         d'un lot de cellule(s) mémoire de la colonne   │
└─────────────────────────────────────────────────────┘
                          │
                          ▼
┌─────────────────────────────────────────────────────┐
│         Fermeture de chaque commutateur tertiaire     │─── 215
│              dudit lot de cellule(s) mémoire          │
└─────────────────────────────────────────────────────┘
                          │
                          ▼
┌─────────────────────────────────────────────────────┐
│        Pilotage de chaque commutateur  primaire dudit │─── 220
│     lot de cellule(s) mémoire, avec une alternance d'ouverture(s) │
│        et de fermeture(s) au cours d'un cycle de lecture. │
└─────────────────────────────────────────────────────┘
                          │
                          ▼
┌─────────────────────────────────────────────────────┐
│           Obtention d'une somme pondérée de           │─── 230
│            valeur(s) de memristor(s) dudit lot        │
└─────────────────────────────────────────────────────┘
```

## FIG.13

**RÉFÉRENCES CITÉES DANS LA DESCRIPTION**

**Documents brevets cités dans la description**

- US 20120287697 A1

- US 10482953 B1

**Littérature non-brevet citée dans la description**

- **S. JUNG et al.** A crossbar array of magnetoresistive memory devices for in-memory computing. *Nature*, 12 January 2022